# EUROPEAN PATENT SPECIFICATION

(11) **EP 3 631 477 B1**
(45) Date of publication and mention of the grant of the patent: **13.03.2024**
(21) Application number: 18725204.4
(22) Date of filing: 16.05.2018
(51) Int. Cl.: G01R 29/08

(54) **MEASUREMENT SYSTEMS, METHODS FOR PROVIDING SUCH SYSTEMS AND METHODS FOR MEASURING ELECTROMAGNETIC RADIATION OF A DEVICE UNDER TEST**
MESSSYSTEME, VERFAHREN ZUR BEREITSTELLUNG SOLCHER SYSTEME UND VERFAHREN ZUR MESSUNG ELEKTROMAGNETISCHER STRAHLUNG EINER ZU PRÜFENDEN VORRICHTUNG
SYSTÈMES DE MESURE, PROCÉDÉS POUR FOURNIR DE TELS SYSTÈMES ET PROCÉDÉS POUR MESURER UN RAYONNEMENT ÉLECTROMAGNÉTIQUE D'UN DISPOSITIF À L'ESSAI

(30) Priority: 31.05.2017 EP 17173797
(43) Date of publication of application: 08.04.2020
(73) Proprietor: Fraunhofer-Gesellschaft zur Förderung der angewandten Forschung e.V., 80686 München (DE)
(72) Inventor: LEATHER, Paul Simon Holt, 10587 Berlin (DE); HAUSTEIN, Thomas, 10587 Berlin (DE); SAKAGUCHI, Kei, 10587 Berlin (DE); THIELE, Lars, 10587 Berlin (DE); ASKAR, Ramez, 10587 Berlin (DE)
(74) Representative: König, Andreas Rudolf
(86) International application number: PCT/EP2018/062772
(87) International publication number: WO 2018/219652

(56) References cited:
- EP-A1- 1 762 840
- EP-A2- 0 903 566
- WO-A1-2015/149133
- WO-A2-2006/055961
- JP-A- 2002 257 932
- US-A1- 2002 067 317
- US-A1- 2004 155 824
- US-A1- 2007 001 895
- US-A1- 2008 180 336
- US-A1- 2011 043 403
- US-A1- 2011 075 127
- US-A1- 2013 271 317
- US-A1- 2013 285 853
- US-A1- 2015 219 704
- US-A1- 2015 285 898
- US-B1- 6 531 989

## Description

The present invention relates to measurement systems, to methods for providing the same and to methods for measuring electromagnetic radiation of a Device under Test (DuT). The present invention further relates to a method for enhancing multi-sensor over the air (OTA) measurements of antennas or array antennas with dielectric lenses in front of planar (array) antennas.

In over the air (OTA) measurements of array antenna properties, the space or sphere around the antenna array has to be sampled in order to derive information about beam pattern(s) while activating various sample beams for reference proposals. Such sampling can be achieved by moving a scan around the array antenna, rotating the array antenna or by a combination of the two.

Current OTA measurement methods of (array) antennas can be categorized into two main methods:
- Method A: move a sensor in space or along a sphere around the emitting (array) antenna in near or far field, wherein near filed measurement requires post-processing to transform sampled field from near to far field.
- Method B: keep position of sampling sensor (array) fixed in space and rotate (array) antenna along various axes. This again can be performed in near field and/or far field.

In order to reduce measurement time, e.g., in production cycles and support multi-beam measurements needed for simultaneous multi-user multiple input multiple output (MIMO) multi-sensor approaches have been proposed, e.g., to distribute multiple sensors within a sphere around the (array) antenna. Such installations can therefore become large, bulky, costly and associated with lots of technical challenges.

Furthermore, such OTA measurement setups should be a kind of generic to support various types of (array) antennas, frequency bands, measurement tasks, etc.

Depending on the (array) antenna geometry, e.g., a number of individual antenna elements to form a group antenna, carry a frequency bands and the kind of OTA measurements to be performed, the number and/or position of sampling points in space/on a sphere can vary significantly and have to be adapted. This often results in a need to reconfigure the sensor setup or extend measurement times.

US 2013/0285835 A1 relates to a system for monitoring communication in a wireless network. The system comprises a sniffer device comprising a first antenna, and a beamsplitter having a curved shape and configured to reflect a portion of a beam transmitted by a second antenna toward the first antenna while transmitting a remaining portion of the beam toward a target.

JP 2002-257932 relates to an imaging device including an electromagnetic wave generator and a separator for separating impinging electromagnetic waves.

EP 0 903 566 A2 relates to detection performed over millimeter and submillimeter wavelengths, especially to imaging solutions functioning over a submillimeter-wavelength range.

US 2011/0043403 A1 relates to an apparatus for and a method of imaging an object by means of electromagnetic very high frequency radiation.

WO 2006/055961 A2 relates to a sensor that senses incident RF signals is provided and which is capable of sensing signals in the Gigahertz (GHz) and Teraherzt (THz) range.

US 2007/0001895 A1 relates to a broad-band millimeter wave imaging system with improved thermal resolution as compared to prior art devices.

US 2004/0155824 A1 relates to a small-sized electromagnetic wave measuring apparatus which can measure an electromagnetic wave radiated from an antenna to be measured.

WO 2015/149133 A1 relates to an antenna testing apparatus including a transportable container having a testing chamber that receives an antenna or antenna assembly to be tested in use and an instrument room containing test equipment for use in testing the antenna or antenna assembly.

Thus, there is a need to enhance measurement systems.

It is an object of the present invention to enhance measurement systems and measurements for sensing electromagnetic radiation of a device under test.

The inventors have found that measurement systems and measurements for sensing electromagnetic radiation of a device under test may be enhanced by increasing an amount of information that is acquired by a sensor array. According to a first aspect this may be obtained by using a lens structure configured to change a width of an electromagnetic beam. By changing the width of the beam, same can be adapted to the configuration of the sensors so as to enhance exploiting the capabilities of the sensors. According to a second aspect, measurement systems and methods for sensing the electromagnetic radiation may be enhanced by providing a dynamic relative movement between a device under test emitting the electromagnetic beam and the sensor array. The dynamic movement may allow for an increase of sensed information.

The invention is defined by a measurement system according to claim 1 and the associated method according to claim 15. In the following, a first aspect comprising embodiments of the invention as well as examples not falling within the subject-matter for which protection is sought and a second aspect comprising examples not falling within the subject-matter for which protection is sought, are presented.

According to an embodiment of the first aspect, a measurement system comprises a placement structure configured to hold a device under test, a sensor array configured to sense an electromagnetic radiation from the device under test at a radio frequency and a beam pattern manipulator structure effective at the radio frequency configured to manipulate a beam of the electromagnetic radiation, i.e., an electromagnetic wave and/or a beam pattern traveling between the DuT and the sensor array. In case of a DuT transmitting a signal, the beam may travel from the DuT to the sensor array, wherein in case of a DuT that is tested with respect to its reception properties, the beam may travel into a direction of the DuT. I.e., the sensors may become probes creating an electromagnetic field from the outside and the antenna array may receive/suppress specific signals by applying selected beamforming weights. Manipulation of the beam may be obtained, by way of example, by use of lens structures and/or reflecting structures. The beam pattern manipulator structure comprises a lens structure configured to change the width of the beam when traveling along a radiation direction through the lens structure, wherein the lens structure comprises a varying shape along a lens direction perpendicular to the radiation direction such that at varying positions of the lens structure along the lens direction between the DuT and the sensor array, a varying effect of the lens structure with respect to the beam is obtained. This may allow for multi-functional lenses that allow for different measurement setups using a single structure at different positions. The measurement system comprises an actuator configured to move the beam pattern manipulator structure with respect to the DuT so as to vary the change of the width of the beam. This may allow for a varying test condition with a low amount of time effort between different configurations.

According to an embodiment of the first aspect, the lens structure effective at the radio frequency. The lens structure is configured to be arranged between the replacement structure and the sensor array and to change a width of a beam of the electromagnetic radiation, the beam traveling from the device under test to the sensor array. This allows for focusing and/or widening of the electromagnetic beam using the lens structure so as to adapt the width of the beam to the sensor array and/or the measurement to be performed.

According to an embodiment of the first aspect, the lens structure comprises at least partially a concave, convex and/or cylindrical shape. This may allow for adapting the change of the width using the respective lens structure.

According to an embodiment of the first aspect, the lens structure extends along a main direction between a first end a second end perpendicular to a radiation direction of the lens structure. The lens structure comprises a convex shape at the first end and comprises a polygon shape at the second end. This may allow for a varying degree of the convex shape which may be almost negligible at the second end having the polygon shape. Therefore, a varying degree of focusing of the width of the beam may be obtained by a varying position.

According to an embodiment, the measurement system comprises an adapter structure being transparent for the electromagnetic radiation and being mechanically connectable to the device under test at a first side and to the lens structure at the second side. The adapter structure may allow for reducing or preventing scattering of the electromagnetic beam at outer surfaces or interfaces between the material of the lens structure and air.

According to an embodiment of the first aspect, the adapter structure comprises a same material as the lens structure. This may allow for a low amount of scattering at a surface between the adapter structure and the lens structure. According to an embodiment of the first aspect, the lens structure comprises a coating. The coating may allow to obtain a low amount of reflection and/or a low amount of standing wave effects inside the lens, e.g., for multi-beam coupling.

According to an embodiment of the first aspect, the lens structure comprises a rotational asymmetric shape. The actuator is configured to rotate the lens structure such that the lens structure is configured to direct the beam into a first direction in a first position of the lens structure and to direct the beam into a second direction in a second position of the lens structure. This may allow for directing the electromagnetic beam into varying different directions and/or to varying sensors of the sensor array so as to obtain a high amount of measurement information.

According to an embodiment of the first aspect, the measurement system comprises an actuator configured to generate a relative movement between the device under test and the sensor array. This may allow to obtain a movement between the beam and the sensor array such that the beam travels towards different sensors of the sensor array. This allows for a high amount of measurement information.

According to an embodiment of the first aspect, the measurement system comprises a control unit configured to control the actuator so as to at least temporarily provide for a quasi-static relative movement so as to quasi-statically adapt an orientation of the device under test with respect to the sensor array and to control the actuator so as to provide for a dynamic relative movement superimposing the quasi-static movement. This allows for a combination of the first aspect with the second aspect and thus for a further enhancement of the measurement system and for measurements of electromagnetic radiation.

According to an embodiment of the first aspect, sensors of the sensor array are spaced by a sensor distance with respect to each other. The sensors of the sensor array are configured to sense the electromagnetic radiation with a sampling rate. The measurement system comprises a control unit configured to control an actuator so as to provide for a dynamic relative movement between the device under test and the sensor array with an amplitude of at least 1/100 of the sensor distance. This allows for obtaining a high amount of information when compared to a static orientation between the device under test and the sensor arrangement.

According to an embodiment of the first aspect, the measurement system comprises a first actuator configured to move the lens structure with respect to the device under test so as to vary the change of the width of the beam. The measurement system comprises a second actuator configured to generate a relative movement between the device under test and the sensor array. The measurement assistant comprises a control unit configured to control the second actuator and to control the first actuator such that the lens structure adjusts the beam to a first width at a first relative position of the device under test with respect to the sensor array, and to control the first actuator such that the lens adjusts the beam to a second width at a second relative position of the DuT with respect to the sensor array. This may allow for changing the orientation of a device under test with respect to the sensor arrangement and to simultaneously change the focusing and/or widening of the beam and may thus allow for a precise and time-efficient test.

According to an embodiment of the first aspect, the sensor array is configured to sense a far field of the electromagnetic radiation from the device under test. This may allow for preventing a post-processing that is possibly error-prone and comprises a considerable amount of computational effort. By using the lens structure, measurements may be taken in the far field while keeping an amount of sensors in the sensor array low. Spacing between the low amount of sensors may be compensated at least partially by varying the width of the beam and may allow for effectively adapting the sampling density of the sensor array.

According to an embodiment of the first aspect, the beam pattern manipulator structure comprises a reflector structure configured to at least partially reflect the beam from a first direction into a second direction along which the DuT is arranged starting from the reflector structure. This may allow for increasing a travelling distance of the beam and/or a small measurement arrangement.

According to an embodiment of the first aspect, the reflector structure comprises a non-planar surface to reflect the beam. This may allow to focus or defocus the beam.

According to an embodiment of the first aspect, the reflector structure comprises a reconfigurable surface and an actuator configured to reconfigure a shape of the surface so as to adapt a reflection property of the surface. This may allow for a high adaptability of the measurement system.

According to an embodiment of the first aspect, a reflecting surface of the reflector structure is configured to reflect the beam and comprises at least one irregular structure at the reflecting surface, the irregular structures being irregular with respect to the reflecting surface. This may allow to adapt the reflection for precise measurements.

According to an embodiment of the first aspect, the irregular structure is an iris structure in the reflecting surface being at least one of configured for an absorption of the beam of at least 50 %; a lens structure arranged at the reflecting surface; and a recess in the reflecting surface. This may allow to increase an overall-dynamic of the measurement when excluding or damping maxima or minima in the beam.

According to an embodiment of the first aspect, the sensor array is arranged between the device under test and the reflector structure and/or wherein the device under test is arranged between the sensor array and the reflector structure. This may allow for diverse measurement setups.

According to an embodiment of the first aspect, the reflecting structure comprises a plurality of irregular structures arranged on a surface of the reflecting structure, wherein the measurement system comprises an actuator configured to rotate the reflecting structure. This may allow to variably influence or manipulate the beam.

According to an embodiment of the first aspect, the reflecting structure comprises at least a first layer structure and at least a second layer structure forming a stack with the first layer structure, wherein the first and second layer structures are moveably with respect to each other and configured to provide for a varying combined reflecting characteristic responsive to a rotational movement between the first and second layer structures. This may allow for a dynamic combination of reflector-effects.

According to an embodiment of the first aspect, the reflector structure is configured to extend an effective distance of the beam to travel between the DuT and the sensor array by at least 50 % when compared to a Line of Sight path between the sensor array and the DuT. This may be done by one or more reflections/deflections performed in the reflector structure and may allow for small measurement systems.

According to an embodiment of the first aspect, the first layer structure is arranged off-center with respect to the second layer structure. This may allow for a varying amount of surfaces of the layers facing the beam.

According to an example relating to the second aspect, a measurement system comprises a placement structure configured to hold a device under test and a sensor array configured to sense an electromagnetic radiation from the device under test at a radio frequency. The measurement system comprises an actuator configured to generate a relative movement between the device under test and the sensor array and a control unit configured to control the actuator so as to at least temporarily provide for an orienting relative movement so as to quasi-statically adapt an orientation of the device under test with respect to the sensor array. The control unit is configured to control the actuator so as to provide for a dynamic relative movement superimposing the orienting movement.

According to an example of the second aspect, the sensor array comprises a plurality of sensors spaced with respect to each other by a sensor distance, wherein the sensors of the sensor array are configured to sense an electromagnetic radiation from the device under test at the radio frequency with a sampling rate. The control unit is configured to control the actuator so as to provide the dynamic relative movement between the device under test and the sensor array with an amplitude of at least 1/100 of the sensor distance.

According to an example of the second aspect, the measurement system comprises a lens structure effective at the radio frequency. The lens structure is configured to be arranged between the placement structure and the sensor array and to change a width of a beam of the electromagnetic radiation, the beam traveling from the device under test to the sensor array. Thus, a combination of the second aspect with the first aspect is possible so as to further enhance the advantages of the second aspect.

According to an example of the first aspect, a method for providing a measurement system comprises providing a placement structure configured to hold a device under test and arranging a sensor array configured to sense an electromagnetic radiation from the device under test at a radio frequency. The method comprises arranging a lens structure effective at the radio frequency. The lens structure is configured to be arranged between the placement structure and the sensor array and to change a width of the beam of the electromagnetic radiation, the beam traveling from the device under test to the sensor array.

According to an embodiment of the first aspect, a method for measuring the electromagnetic radiation of a device under test comprises holding the device under test with a placement structure, controlling the device under test so as to radiate a beam at the radio frequency, the beam traveling between the device under test and the sensor array. The method comprises a lens structure effective at the radio frequency between the placement structure and a sensor array. The method comprises sensing the beam with the sensor array and moving the lens structure so as to change a width of the beam. That the lens structure is configured to change the width of the beam when traveling along a radiation direction through the lens structure, such that the lens structure comprises a varying shape along a lens direction perpendicular to the radiation direction such that at varying positions of the lens structure along the lens direction between the DuT and the sensor array, a varying effect of the lens structure with respect to the beam is obtained. The method is performed such that the measurement system comprises an actuator configured to move the beam pattern manipulator structure with respect to the DuT so as to vary the change of the width of the beam.

According to an example of the second aspect, a method for providing a measurement system comprises providing a placement structure configured to hold a device under test, arranging a sensor array configured to sense an electromagnetic radiation from the device under test at a radio frequency and arranging an actuator configured to generate a relative movement between the device under test and the sensor array. The method comprises arranging a control unit configured to control the actuator so as to at least temporarily provide for an orienting relative movement so as to adapt an orientation of the device under test with respect to the sensor array, and to control the actuator so as to provide for a dynamic relative movement superimposing the orienting movement.

According to an example of the second aspect, a method for measuring electromagnetic radiation of a device under test comprises holding the device under test with a placement structure, controlling the device under test so as to radiate a beam at a radio frequency, the beam traveling between the device under test and the sensor array, and comprises controlling the actuator so as to generate a relative movement between the device under test and the sensor array so as to at least temporarily provide for an orienting relative movement so as to adapt an orientation of the device under test with respect to the sensor array. The method comprises controlling the actuator so as to provide for a dynamic relative movement superimposing the orienting movement.

Further embodiments are defined in dependent claims.

Embodiments of the present invention are now described in further detail with reference to the accompanying drawings, in which:
- Fig. 1: shows a schematic block diagram of a measurement system according to an embodiment of the first aspect;
- Fig. 2a: shows a schematic cross-sectional view of a lens structure according to an example relating to the first aspect that comprises a convex shape;
- Fig. 2b: shows a schematic cross-sectional view of a lens structure according to an example relating to the first aspect that comprises a bi-concave shape;
- Fig. 2c: shows a schematic perspective view of a lens structure according to an example relating to the first aspect that comprises partially a cylindrical shape;
- Fig. 2d: shows an example of such a varying lens structure according to an embodiment of the first aspect;
- Fig. 2e: shows a schematic perspective view of a lens structure according to an embodiment of the first aspect, comprising at least at the first end a part of an elliptical or round shape as also illustrated in Fig. 2d;
- Fig. 3a: shows a schematic diagram of parts of a measurement system according to an embodiment of the first aspect, comprising the lens structure of Fig. 2e;
- Fig. 3b: shows a schematic diagram of an increase of an angle ε of an electromagnetic beam of a DuT according to an embodiment of the first aspect;
- Fig. 4: shows a schematic perspective view of the lens structure of Fig. 2c to illustrate the effect of the rotational asymmetric lens structure according to an example relating to the first aspect;
- Fig. 5a: shows a schematic block diagram of a measurement system according to an embodiment of the first aspect, holding the DuT and comprising the lens structure;
- Fig. 5b: shows a schematic diagram of the measurement system of Fig. 5a according to an embodiment of the first aspect, wherein the lens structure comprises a coating;
- Fig. 6: shows a schematic block diagram of a measurement system according to an embodiment of the first aspect, in which the lens structure comprises a recessed side;
- Fig. 7: shows a schematic block diagram of a measurement system according to an example of the second aspect;
- Fig. 8: shows a schematic flowchart of parts of a method for providing a measurement system such as the measurement system according to an example of the first aspect;
- Fig. 9: shows a schematic flowchart of a method for measuring electromagnetic radiation of a device under test according to an example of the first aspect;
- Fig. 10: shows a schematic flowchart of a method for providing a measurement system according to an example relating to the second aspect;
- Fig. 11: shows a schematic flowchart of a method for measuring electromagnetic radiation of a DuT according to an example relating to the second aspect;
- Fig. 12: shows a schematic block diagram of a measurement system according to an example in accordance with the first aspect having a reflector structure;
- Fig. 13: shows a schematic side view of a reflecting structure according to an exampleof the first aspect, comprising a non-planar reflecting surface;
- Fig. 14: shows a schematic side view of a reflector structure according to an exampleof the first aspect comprising an irregular structure at the reflecting surface;
- Fig. 15: shows a schematic view of a reflector structure according to an example of the first aspect comprising two adjacent layer-structures;
- Fig. 16: shows a schematic diagram of a measurement system according to an example of the first aspect, the measurement system comprising a first reflecting structure and a second reflecting structure; and
- Fig. 17: shows a schematic block diagram of a measurement system according to an example of the first aspect, the measurement system comprising the reflector structure having a lens-like irregular structure.

Equal or equivalent elements or elements with equal or equivalent functionality are denoted in the following description by equal or equivalent reference numerals even if occurring in different figures.

Embodiments described herein relate to measurement systems that are configured to test a device under test. Such a device under test may be a device configured for communicating according to a wireless communication standard and/or in a wireless communication network. Non-emitting examples for such devices are Internet of Things (IoT) devices, user equipment and/or base stations/eNB (evolved node B). The DuT may be configured to emit one or more beams, i.e., directed electromagnetic radiation using an antenna array comprising at least one antenna. This may include an almost omnidirectional (at least in one plane) emission when using only a single antenna element in the antenna array. Thus, even when referring to beams emitted by the DuT, this shall not exclude undirected electromagnetic radiation which may be examined or tested without any limitation by a measurement system.

A sensor array that may be described in connections with embodiments may be understood as a plurality of sensors that are distributed in space.

Embodiments described herein may relate to beams. Such a beam may be used for transmitting and/or receiving a signal at radiofrequency with an irregular spatial pattern which may be used for beamforming. In the present embodiments, a beam may be formed for reception and/or transmission, i.e., a preferred direction of the antenna array may be implemented. In case of a DuT transmitting a signal, the beam may travel from the DuT to a sensor array, wherein in case of a DuT that is tested with respect to its reception properties, the beam may travel into a direction of the DuT. Thus, embodiments described in connection with beamforming relate to the transmission scenario and to the reception scenario.

Embodiments described herein may relate to a beam pattern manipulator structure which is a structure configured to manipulate a beam and/or a beam pattern of used for transmitting and/or receiving a signal at radiofrequency. Such a beam pattern manipulator structure may be referred to as an electromagnetic wave propagation direction changing structure and may comprise structures or elements configured for diffraction and/or reflection of the beam, e.g., a lens structure and/or a reflecting structure.

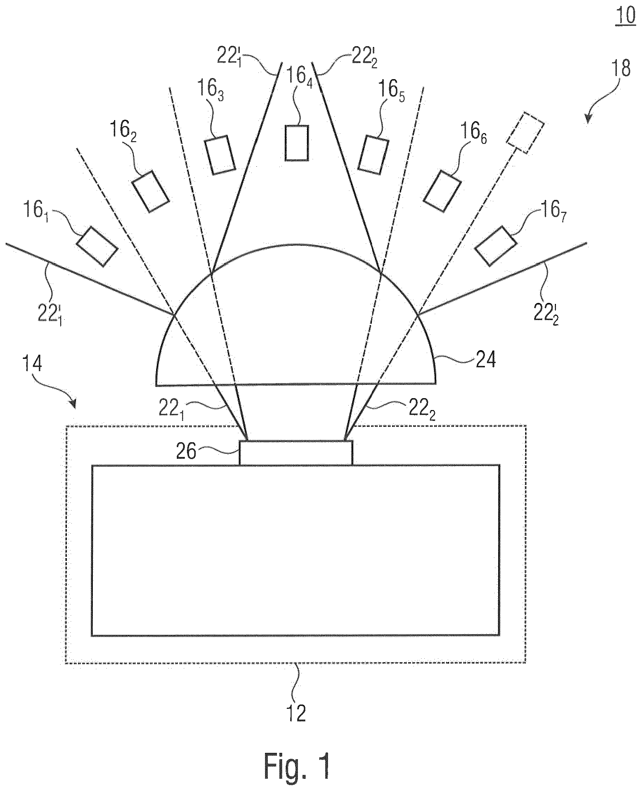

Fig. 1 shows a schematic block diagram of a measurement system 10 according to the first aspect. The measurement system 10 comprises a placement structure 12 configured to hold a Device under Test (DuT). The placement structure may be any suitable place, plane or structure configured to host, hold or fix the DuT 14. Although being illustrated in Fig. 1, the DuT 14 may be an apparatus different from the measurement system 10, i.e., may be not a part of the measurement system 10. The placement structure 12 may be, for example, a measurement table in a reverberation chamber or an anechoic chamber in which measurements in connection with the DuT 14 may be performed. The measurement system 10 comprises a plurality of sensors 16₁ to 16₇ forming a sensor array 18 that is configured to sense an electromagnetic radiation 22 from the DuT 14. The DuT 14 may be configured to emit the electromagnetic radiation 22 in form of beams 22, and/or 22₂ into a direction of the sensor array 18. The beam of the electromagnetic radiation relates to a frequency of the electromagnetic radiation 22 that is at a radio frequency, for example, at least 800 MHz at least 1 GHz, at least 3 GHz or even more, for example, in a millimeter wavelength range that is between 30 GHz and 300 GHz.

The measurement system 10 comprises a beam pattern manipulator structure configured to manipulate the electromagnetic radiation (beam) 22. According to an embodiment, the beam pattern manipulator structure may comprise a lens structure 24 effective at the radio frequency at which the electromagnetic radiation 22 is emitted. As will be described later, alternatively or in addition to the lens structure 24, the beam pattern manipulator structure may comprise a reflector structure for reflecting the electromagnetic radiation 22. The lens structure 24 is configured to be arranged between the placement structure 12 and the sensor array 18. The lens structure 24 is configured to change a width of the beams 22, and/or 22₂. For example, a widening of the beams 22, and/or 22₂ is indicated by the solid lines 22'₁ and 22'₂ when compared to dotted lines that indicate an unmodified width of the beams 22, and/or 22₂.

The lens structure 24 may comprise dielectric material that is configured to act similar to an optical lens for visible light. Example materials may be, for example, a plastic material such as Polytetrafluoroethylene (PTFE) and/or polyethylene or a glass material. The material may not necessarily be optically transparent. Preferably, the material comprises a low attenuation of the electromagnetic radiation (low transmission loss factor) and may therefore vary based on a varying frequency range of the radio frequency.

As known from optical lenses, a shape of the lens structure 24 may influence the change of the width of the beams 22, and/or 22₂. For example, the lens structure may comprise at least partially a concave, convex and/or cylindrical shape. A cylindrical shape may be referred to as a quarter-cylinder, half-cylinder or any other part of a cylinder. The diffracting effect of a shape like a cylinder may also be achieved by more flat structures similar to Fresnel lenses where the curvature varies in a step wise fashion over the surface of the lens like structure. Such mechanical structures are also within the scope of the presented embodiments. Alternatively or in addition, the lens structure may be not limited to mechanical structures but may at least partially implemented by other structures such as electrical structures. For example, an electrical lens may be implemented by generating an electric field, e.g., using a coil. As illustrated in Fig. 1, a complex shape of the lens structure 24 may allow for a widening of the beams 22, and/or 22₂ as indicated by the widened beams 22'₁ and/or 22'₂.

The DuT 14 may comprise an antenna array 26 comprising at least one antenna, but preferably more than one antennas. The antenna array 26 may be configured to adapt a direction of the electromagnetic radiation emitted and may be configured to transmit the beams 22, and/or 22₂ at a same time or at different times. Measurement systems such as the measurement system 10 may be used for evaluating a characteristic or property of the emitted beams 22, and/or 22₂. The measurement system 10 may be adapted to measure a variety of DuT 14 that are implemented different from each other, i.e., a direction and/or a pattern of emitted beams may vary between the DuT. In addition, measurement of the electromagnetic radiation is preferably performed in the far field.

The far field may be determined, by non-limiting example only to be present at a distance from the antenna being at least D = (2L²)/λ, wherein L is the geometric length of the antenna and λ is the wavelength of the emitted signal. The distance between the antenna array 26 and the sensor array 18 may thus comprise a considerable amount. At the same time, a position and/or distance between the sensor elements 16 may allow for a spatial resolution of the sensor elements 16. With an increase of distance between the DuT 14, the antenna array 26, respectively and the sensor array 18 a number of sensor elements 16 has to be increased to maintain the spatial resolution and/or the spatial resolution is decreased which is unwanted. Although measurements may also be taken in the near field, this leads to considerable computational efforts which are unwanted and/or to errors due to computation which are also unwanted.

When viewing the non-limiting example of Fig. 1, the widened beams 22'₁ and/or 22'₂ may be sensed by three sensor elements 16₁, 16₂ and 16₃, 16₅, 16₆ and 16₇, respectively when compared to the unchanged beams 22, and/or 22₂ that would be sensed by a single sensor element 16₂, 16₃, respectively. The numbers given are exemplary values only. Based on different distances between sensor elements 16, the DuT 14 and the sensor array 18 and/or a behavior of the sensor structure 24, different effects and numbers of sensor elements may be obtained.

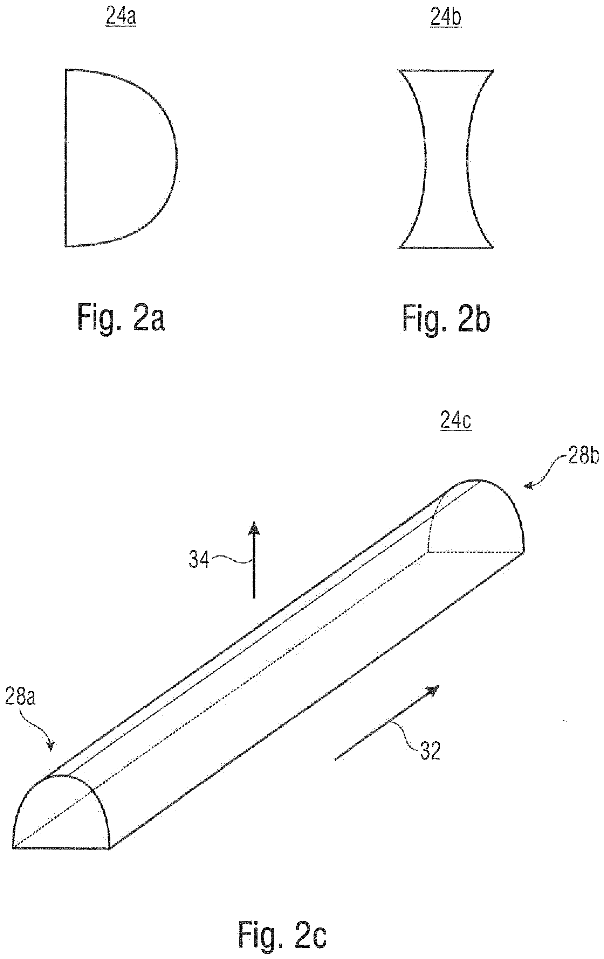

Fig. 2a shows a schematic cross-sectional view of a lens structure 24a that comprises a convex shape.

Fig. 2b shows a schematic cross-sectional view of a lens structure 24b that comprises a bi-concave shape. According to another embodiment, a lens structure may comprise a biconvex shape and/or a concave shape.

Fig. 2c shows a schematic perspective view of a lens structure 24c that comprises partially a cylindrical shape. By non-limiting example only, the lens structure 24c comprises a cross-section being a half-cylinder, i.e., cut along a diameter of a cylinder. Thus, a first end 28a and a second end 28b may comprise a shape of a half-circle. According to other embodiments, the ends or surfaces 28a and 28b may comprise a different shape. The lens structure 24c may be rotational asymmetric along a first axis or direction 32 between the ends 28a and 28b and along a second axis or direction 34 along a direction perpendicular to the direction 32, i.e., along the cross section passed by the radiated pattern/beam along its travel between the DuT and the sensors. For example, the direction 34 may be a direction that is in parallel with a direction along which the beam travels from the DuT into the lens structure 24c in a direction to the sensor array, i.e., a radiation direction.

Along the direction 32 the lens structure 24c may comprise a varying shape which may allow for a varying influence of the lens structure 24c. Thus, the lens structure 24c may comprise a varying shape along the direction 32 such that a varying position of the lens structure 24c along the direction 32 between the DuT and the sensor array 18 yields in a varying effect of the lens structure with respect to the beam. The varying positions may be understood as very many possible positions allowing a smooth transition over many "states" during a measurement, wherein in each position a specific manipulation may be obtained such as to changing/widening and/or narrowing the emitted beam pattern into a specific direction and/or projecting it towards the distributed sensors. This may be obtained, for example, by a continuous modification of the position.

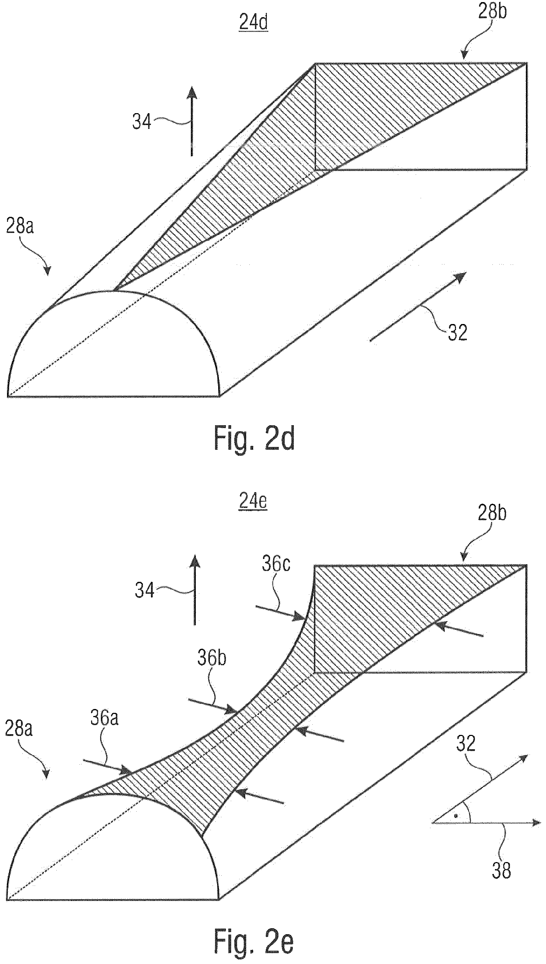

Fig. 2d shows an example of such a varying lens structure 24d. The lens structure 24d may extend along a main direction that is the axis 32. At the first end the lens structure 24d may comprise a convex shape as shown, for example, in Figs. 2a and 2c. At the second end 28b the lens structure 24d may comprise a polygon shape, such as a rectangular shape or the like. Based on two different shapes at the ends 28a and 28b a varying position of the lens structure 24d with a varying point along the direction 32 being between the antenna array of the DuT and the sensor array of the measurement system leads to a varying effect of the lens structure 24d with respect to the beams traveling through the lens structure 24d.

Fig. 2e shows a schematic perspective view of a lens structure 24e comprising at least at the first end 28a a part of an elliptical or round shape as also illustrated in Fig. 2d. At the second end, the lens structure 24e comprises the polygon shape. Also being illustrated as a rectangular shape, a different polygon may be used, for example, a regular polygon that comprises at least one flat surface that may be arranged towards the antenna array or the sensor array. The polygon may also comprise a second flat surface being arranged opposite to the first flat surface which is possible, for example, for regular hexagon or higher order to n shapes. Between the first end 28a and the second end 28b a different 3D-shape may be present that allows for effectively changing the radiated pattern by diffraction.

In addition to the description made with respect to the lens structure 24d, the lens structure 24e may comprise a varying extension 36a, 36b and 26c along a direction 38 being perpendicular to the directions 32 and 34. The extensions 36a to 36c may be referred to as a width, by a non-limiting example only. According hereto, the direction 32 may be understood as a length and the direction 34 as a height of the lens structure 24e, wherein the names given are mutually exchangeable when changing an orientation of the lens structure 24e in space.

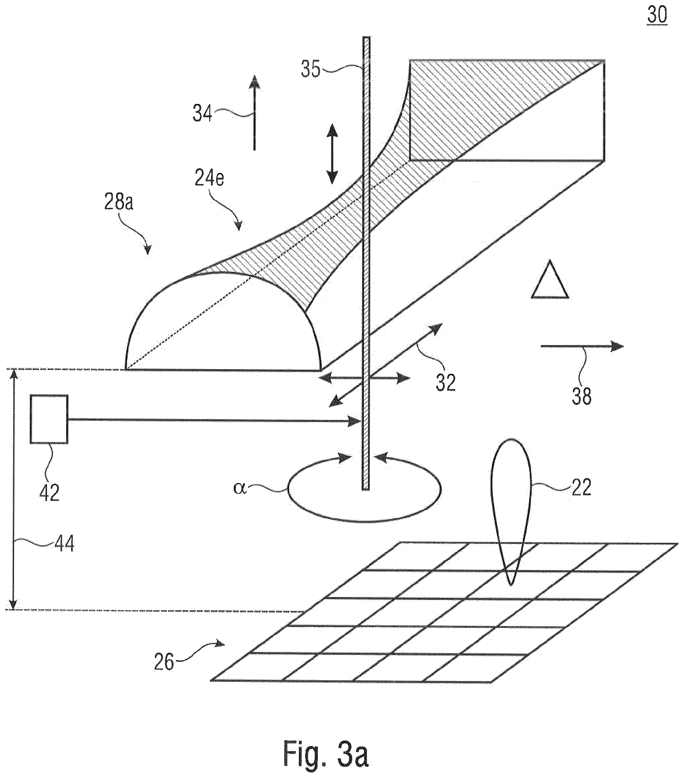

Fig. 3a shows a schematic diagram of parts of a measurement system 30 comprising the lens structure 24e being arranged near to the antenna array 26 that may be implemented, for example, by 8x8 antenna elements. The measurement system 30 comprises an actuator 42 configured to adapt a relative position of the lens structure 24e with respect to the antenna array 26 and/or the sensor array of the measurement system 30. For example, the actuator 32 may be configured to linearly shift the lens structure 24e along the direction 32 so as to adapt a behavior of the optical structure 24e with respect to the electromagnetic radiation of the antenna array 26. The shift may comprise a value D that may comprise, for example, a maximum value that is at least a length of the lens structure 24e.

Alternatively or in addition, the actuator 42 may be configured to linearly shift the lens structure 24e along the direction 38 and/or to rotate the lens structure 24e, for example, in the plane being defined by the directions 32 and 38. The rotation may be performed by a rotation angle alpha that may be, for example, an analog or digital value of at least 90°, at least 180°, or even 360°. Alternatively or in addition, the actuator 42 may be configured to adapt a distance 44 between the lens structure 24e and the antenna array 26.

According to embodiments, one or more different or further lens structures such as the lens structure 24, 24a, 24b, 24c, 24d and/or 24e may be arranged in the measurement system 30. Each of the described movements may be configured to vary the change of the width of the beam being obtained by using the respective lens structure.

Lens structures such as the lens structures 24c, 24d and 24e may comprise a rotational asymmetric shape. The actuator 44 may be configured to rotate the lens structure such that the lens structure is configured to direct the beam into a first direction in a first rotational system (angle alpha) of the lens structure and to direct the beam into a second direction in a second position of the lens structure. For example, when the first end 28a of the lens structure 24e is arranged so as to widen the beam 22 of the antenna array 26, then a varying angle between a curved surface at the first end 28a and the beam 22 due to the rotation around an axis 35 that may be parallel to the radiation direction 34 and/or arranged along a center of the antenna array 26 may lead to a varying direction along which the beam is emitted.

In other words, embodiments provide a solution for enhancement in OTA measurements of array antenna beamforming properties in a measurement setup regarding angular resolution with a given sensor distribution. Furthermore, the improved configuration may allow for a faster scanning procedure during production cycle measurements. In higher frequencies above 6 GHz, e.g., millimeter wave, dielectric lenses may be used for changing emitted beam patterns. Preferably, the measurement of a single user and multi-user beamforming may be possible per user in the same or different bands, such that per user a beamforming (BF) may be supported. Such multi-user beamforming may relate to a simultaneous creation of multiple spatial beams at the same time. The beams may be emitted in the same part of the spectrum or in overlapping or disjoint parts. One aspect thereof may include that the OTA measurement system may be implemented to measure these beams and their spatial relationship in situ OTA. For instance, one beam directs his main lobe to one user or direction while a spatial NULL (as little energy as possible to be transmitted into a specific direction/area) is placed towards another user or direction at the same time and vice versa with a second user. In such a way cross beam interference could be measured considering various user or direction constellations in space and selected beam formers.

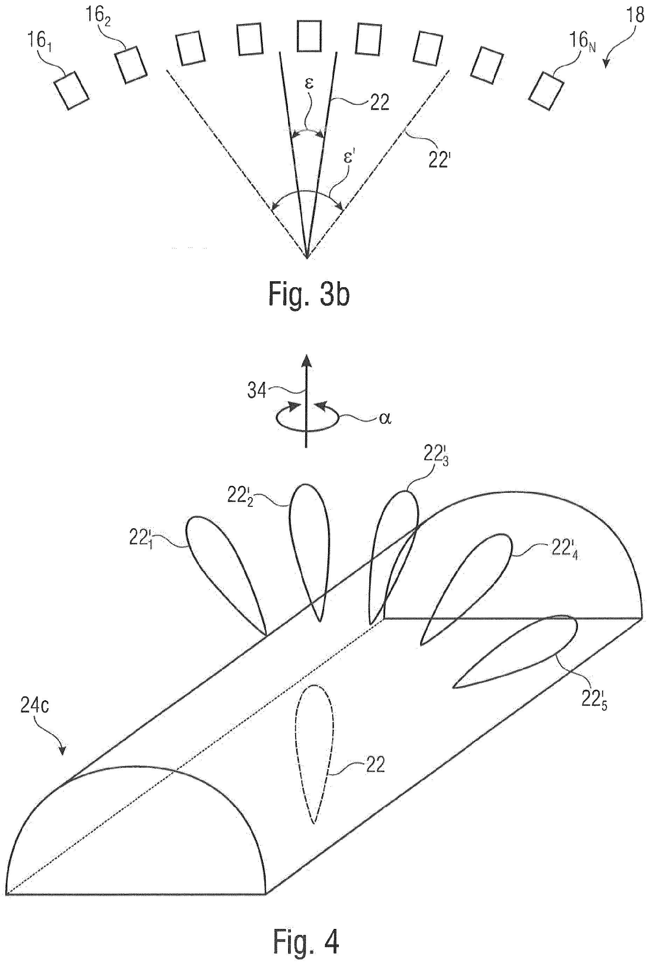

Fig. 3b shows a schematic diagram of an increase of an angle ε of a beam of the DuT 14. When measuring the electromagnetic radiation in the far field, a specific distance may be present between the antenna of the DuT and the sensor elements 16 of the sensor array 18. Such a distance may, for example, at least 30 cm, at least 40 cm or at least 50 cm. For example, the DuT may be configured to emit a narrow beam having an opening angle ε, by non-limiting example only, 3°. For measuring such a beam, a slow movement of the DuT with respect to the sensor array 18 may be necessary, for example, because the beam 22 only hits a single sensor element 16₁ (or another low number). Thus, a specific measurement time has to be taken by this low amount of sensor elements. By increasing the angle to an angle ε', being, for example, greater by a factor of 3, 4, 5 or more and possibly 15°, a higher amount of sensor elements is hit by the widened beam 22' which may allow for a faster movement of the DuT as more sensor elements commonly provide for the measurement time.

The lens structure may thus vary the observation area. This may be a similar function as an optical zoom with optical lenses. A varying position of the lens structure 24 with respect to the antenna array of the DuT and/or an absence or presence of the lens structure may allow to switch between a functionality according to a telephoto lens and a wide-angle lens. For example, in regions where main lobes or beams superimpose with each other, a precise measurement may be necessary or wanted. In such regions, the lens 24 may be arranged and/or positioned so as to widen the beam which allows to measure the beam with a higher spatial resolution. A zero of the radiation pattern may be evaluated with an inverse wide-angle lens, i.e., a telephoto lens. Aside such superimposing regions, a single wide-angle lens may be suitable to scan the respective area.

Fig. 4 shows a schematic perspective view of the lens structure 24c of Fig. 2c to illustrate the effect of the rotational asymmetric lens structure. Based on a rotation around the axis 35 a beam 22 traveling through the lens structure 24c may be directed into a variety of different directions as indicated by the 22'₁ to 22'₅.

In other words, a use of an e.g., non-rotation symmetric lens may allow to distort the emitted beam-patterns depending on the relative angle between the antenna array 26 and the lens structure.

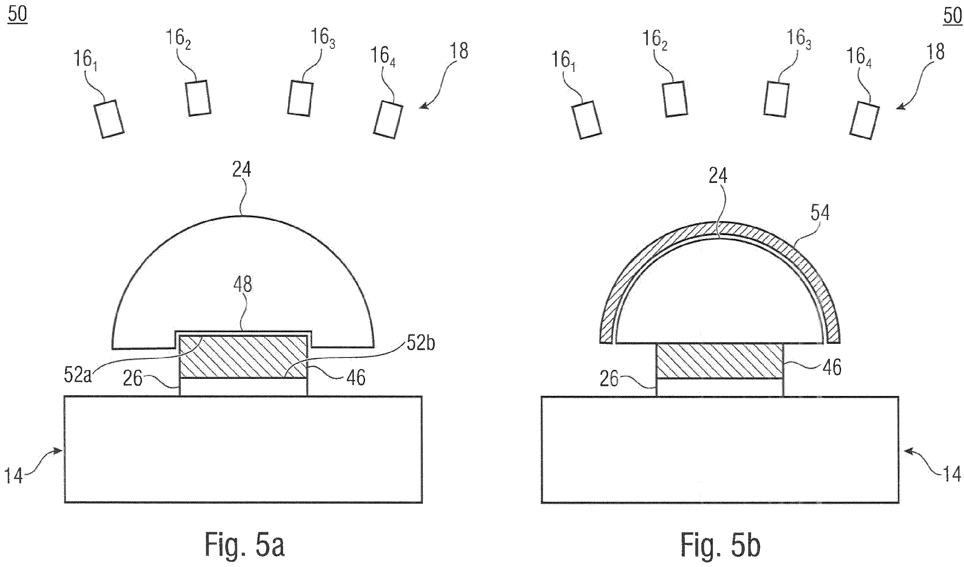

Fig. 5a shows a schematic block diagram of a measurement system 50 holding the DuT 14 and comprising the lens structure 24. The measurement system 50 comprises an adapter element 64. The adapter element 64 may be transparent for the electromagnetic radiation of the antenna array 26 and may be mechanically connectable to the DuT 14, the antenna array 26, respectively, and to a side 48 of the lens structure 24. For example, the side 48 may be or may at least comprise a recess in the lens structure 24 so as to at least partially host the adapter element 46. This may allow to fix the adapter element 46 against a lateral movement with respect to the lens structure 24. For example, the adapter element 46 may comprise a shape being similar to a circular, elliptic or polygon-shaped disk. A first main side 52a of the adapter element 46 may be adaptable to the side 48 of the lens structure 24. An opposing second main side 52b of the adapter element may be connectable to the antenna element 56. The adapter element 46 may allow for a support of a relative movement of the lens structure 24 with respect to the antenna array 26, for example, a rotation of the lens structure.

The adapter element may alternatively or in addition allow for a low loss or diffraction between the antenna array 26 and the lens structure 24. For example, the adapter element 46 may be formed of a same material as the lens structure 24. According to another embodiment, a material with equal or at least similar reflection/transmission coefficients or with known reflection/transmission coefficients may be used, even if a step may cause additional diffraction as e.g. between air and glass. A similar reflection/transmission coefficient may be arranged within a tolerance range of at most 15 %, at most 10 % or at most 5 % of another reflection/transmission coefficient. Using the same material may allow that the combined structure behaves similar to a single piece structure of the same shape and material.

Fig. 5b shows a schematic diagram of the measurement system 50 comprising the lens structure 24, wherein the lens structure 24 comprises a coating 54. A coating such as the coating 54 may allow for a low or even minimal reflection so as to reduce standing wave effects inside the lens structure 24, e.g., when using a multi-beam to be influenced with the lens structure 24, i.e., a coupling between the multiple beams may be avoided or reduced. The coating 54 may be adapted for being effective at the radio frequency, e.g., it may allow for polarizing the incoming beam during reflection and/or for implementing a half-reflecting lens, that combines a reflector with a lens property when reflecting a first amount of the beam and manipulating a second amount with the lens functionality. A thickness of the coating may be a factor to steer the reflection coefficient and may be chosen appropriately for the desired effect. The coating 54 may comprise one or more suitable materials such as a metal material like copper, aluminum, gold or the like, or any other material creating a suitable reflection coefficient for the given frequency of the radio transmitter. Such a coating may be deposited or generated, for example, using processes to put the coating material on cleaned surfaces by vaporizing material in a chamber and exposing the surface to the vapor over a specific time. Alternatively or in addition, spraying and electrolytic coating are further options, especially if the later can be charged electrically for a better electrolytic process. The coating 54 may have the purpose of filtering part of the spectrum or partial reflection or fixed/adaptive or gradual attenuation. The coating may also implement location selective transparency so as to an iris structure. Furthermore different layers of coating may be combined, e.g., a gray wedge and a frequency/spectrum selective filter so as to implement a measurement of a beam alignment between beams simultaneously at different frequencies e.g. 28 GHz and 39 GHz. Furthermore the coating itself and the coating in combination with the diffractive material could be applied as polarization selecting combining structure. For example: a Brewster angle under which specific polarizations virtually disappear because they are neither reflected or diffracted. This may be used in photography to suppress/enhance reflection on dielectric surface like windows, water etc. Thus, the coating 54 may adapt the coated structure to apply a polarization selecting or polarization changing property. For example, a mirror may be implemented semitransparent and may be arranged under 45° with respect to the beam of a polarized electromagnetic source such as a LED (Light Emitting Diode), a laser and a mm-Wave Source. The deflected ray may be directed under another 45° (perpendicular to a plane of the separated rays of the first splitting) such that a rotation of the polarization may be affected. By this way, a change or rotation of the polarization may be obtained and different polarization properties may be tested/measured with the sensors.

Different to the measurement system in Fig. 5a, the lens structure 24 may comprise a flat surface connectable to the adapter element 46.

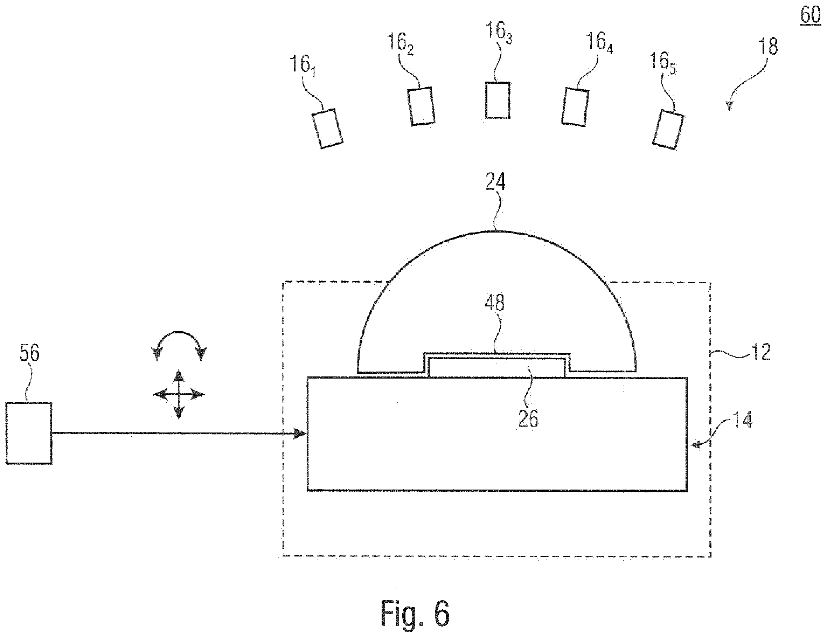

Fig. 6 shows a schematic block diagram of a measurement system 60 according to an embodiment. The measurement system 60 may comprise the lens structure 24 comprising the recessed side or surface 48 so as to allow for a low loss even in absence of the adapter structure 46. Independent hereto, the measurement system 60 may comprise an actuator 56 being configured to provide for a relative movement between the DuT 14 and the sensor array 18. This may comprise a lateral movement along one, two, or three axes and/or a rotational movement around one, two or three axes. Thus, a varying orientation of the DuT with respect to the sensor array 18 may be obtained. The movement of the actuator 56 may be understood as orienting movement or quasi-static relative movement that allows for a varying orientation to be examined with the sensor array 18. The quasi-static movement may be, for example, a continuous movement that is slow enough to allow the sensor array 18 to examine the respective orientation and/or may be a discontinuous movement that allows the DuT 14 to have a rest position in a respective orientation to be examined by the sensor array 18. Thus, with respect to a running test, the orienting relative movement or quasi-static relative movement may me zero or negligible, wherein the dynamic movement may provide for the enhancement of the test. According to an example, the dynamic movement may be implemented by implementing a swing-movement and may be predictive, aforesaid and/or repeatedly performed. In the extreme points of the swing movement, the movement may be quasi zero for a certain period of time. After that the velocity increases again but with inversed sign/direction until it decelerates at the other extreme point of the swing movement and comes to a still. In the middle of the trajectory the velocity may show a maximized value with different/opposing directions each time. Measurement setups may exploit the knowledge when and where the sampling happens so as to enable a deeper and additional signal analysis to be extracted from the movement.

Although the actuator 56 is illustrated as being configured to move the DuT 14, the actuator 56 may also be configured to move the sensor array 18 so as to provide the relative movement between the DuT and the sensor array 18. A movement of the DuT 14 may allow for a more easy and robust measurement setup.

The measurement system 60 may also comprise the actuator 42 which may allow for examining the radiation emitted by the DuT 14 in various orientations with respect to the sensor array 18 and with various positions of the lens structure relative to the antenna array 26.

Although the actuator 56 is illustrated as being mechanically connected to the DuT 14, the placement structure 12 respectively, the filter 56 may also be connected to the sensor array 18 so as to provide for the relative movement.

According to embodiments, a measurement system may comprise the actuator 42 and/or the actuator 56. The actuator 42 may be configured to move the lens structure 24 with respect to the DuT 14 so as to vary the change of the width of the beam 22. The actuator 56 may be configured to generate a relative movement between the DuT 14 and the sensor array 18. Such a measurement system may comprise a control unit configured to control the actuator 56 and to control the actuator 42 such that the lens structure adjusts the beam to a first width at a first relative position of the DuT with respect to the sensor array 18 and to control the first actuator such that the lens adjusts the beam to a second width at a second relative position of the DuT 14 with respect to the sensor array 18.

In other words, embodiments of the first aspects comprise the following elements that may be implemented independently from each other but may also be combined with each other.
1. Use a single antenna element or an array of multiple antenna elements, wherein the array is linear, two-dimensional, three-dimensional, planar or conformal.
2. Put a rotation or non-rotation symmetric lens that may be matched to the wavelength to be used in a beamforming of the DuT, in front of the antenna.
3. Put a kind of disk, i.e., an adapter structure, or other shape of the same material like the lens directly onto the antenna of the DuT in order to get the emitted wave fully encaptured into the diffracting lens.
4. Use coating on lens with minimal reflection to reduce standing wave effects inside the lens for, e.g., multi-beam coupling.
5. Use multiple sensors placed around the DuT.

For a given spatial distribution of multiple sensors, sampling in space and therefore in angular domain around the DuT may be fixed within a measurement system. Next, the antenna or array antenna of the DuT may be rotated against the lens around an axis, e.g., perpendicular to the lens flat surface facing the (array) antenna, e.g., when a planar array is arranged at the DuT. By using a non-rotation symmetric lens, the emitted beam will change its effective outbound direction depending on the frequency, the diffraction coefficient and the shape and orientation of the lens. Furthermore, the lens can be shifted perpendicular against the rotation axis in order to exploit more degrees of freedom for beam distortion/diffraction. This allows a variable positioning of the beam to be measured against the multiple sensors which are fixed in space around the DuT.

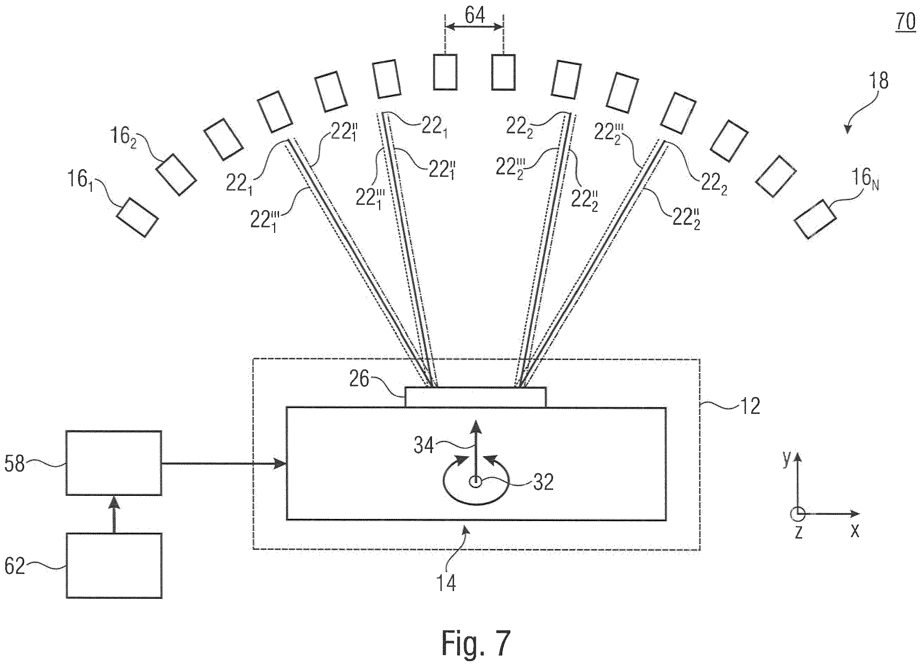

Fig. 7 shows a schematic block diagram of a measurement system 70 according to the second aspect. The measurement system 70 comprises the placement structure 12 configured to hold the DuT 14. The measurement system 70 comprises the sensor array 18 comprising a number of N sensor elements 16.

The measurement system 70 is configured to change a position of the beam relative to the sensor array 18. The sensor array 18 may comprises a regular and/or randomized spatial pattern of the sensors 16₁ to 16_{N}. Changing the position may include a continuous or discontinuous movement of the DuT relative to the sensor array 18 and/or may include a varying direction of the beam relative to the DuT. In both cases, the beam may move with respect to the sensor array. The measurement system 70 may comprise an actuator 58 configured to generate a relative movement between the DuT 14 and the sensor array 18. Such a movement may also be obtained when using the actuator 42 and/or 56 as the actuator 58. The measurement system 70 comprises a control unit 62 configured to control the actuator 58 so as to at least temporarily provide for a quasi-static relative movement so as to quasi-statically adapt an orientation of the DuT with respect to the sensor array 18 as described in connection with Fig. 6. Additionally, the control unit 62 is configured to control the actuator 58 so as to provide for a dynamic relative movement superimposing the quasi-static movement. When compared to the quasi-static movement, the dynamic movement may comprise a low amplitude but, in contrast, a high frequency so as to move the DuT 14 back and forth around, by a non-limiting example only the axis 35.

Also being illustrated as a rotational movement, the dynamic movement may be a lateral movement along a direction x, y and/or z and/or a rotational movement around a different axis perpendicular to the axis 35 such as the axis 32. The dynamic movement may be performed according to a linear (straight) or non-linear (e.g., curved or circular) swing-movement. In the extreme points of the swing movement, the movement may be quasi zero for a certain period of time. After that the velocity increases again but with inversed sign/direction until it decelerates at the other extreme point of the swing movement and comes to a still. In the middle of the trajectory the velocity may show a maximized value with different/opposing directions each time. Measurement setups may exploit the knowledge when and where the sampling happens so as to enable a deeper and additional signal analysis to be extracted from the movement. A speed of the movement and/or frequency of the movement may adjust a degree of the additional information as well as a changing sensor sampling rate. In other words, by moving the beam with respect to the sensors, each sensor may perform measurements in different regions of the beam. The movement of the beam may be obtained by moving the DuT and/or by moving the beam, e.g., by changing a direction of the beam relative to the DuT. For example, to measure a beam having an opening angle of 3°, a single sensor may be used, when allowing the beam to move for ±1.5° when being centered with respect to the sensor. Thereby a superresolution may be obtained, i.e., a higher resolution when compared to the spatial distribution of the sensors of the sensor array 18.

The dynamic movement may allow for a changed position of the arrays 22, and/or 22₂ when hitting the sensor array 18. This is indicated by a dashed/dotted line referenced with 22"₁, 22"₂, respectively, indicating a movement along a first direction and a dotted line 22‴₁ and 22‴₂, indicating a movement along an opposing direction. This dynamic movement may allow for a kind of increase of the spatial resolution of the sensor array 18 even if the movement is little. A comparable effect was detected by astronauts on the ISS that were able to see single ships on the oceans with their naked eyes. Although this was thought to be impossible due to the limitations of the human eye, it was found that by an instinctive small but rapid movement of the eyes back and forth, the resolution that may be reconstructed with the human brain is higher than the resolution of images captured with the eyes. A similar effect may be obtained with the measurement system 17.

Sensor elements 16 of the sensor array 18 may be spaced from each other by a sensor distance 64 that is, for example, at least 0,1 mm and at most 5 m, at least 1 mm and at most 5 cm or at least 2 mm and at most 2 cm. In other words, the spacing may be one or a few centimeters, e.g., depending on the size/housing of the sensor. Using an appropriate structure, the distance might be smaller as well. In some cases, known sensors like Vivaldi antennas are broadband but a bit bulky. According to other embodiments, a largest distance can be easily up to a few meters. A smallest distance to result in desired/required maximum sampling resolution and a maximum distance to be equivalent to the maximum sampling scan in space at a given measurement setting or given the maximum distance in space/angle of two or more patterns which need high resolutions sampling at the same time. This may be implemented by two or more dense sensor clusters at a quite a distance in space. The sensor elements 16 may be configured to sample the beams 22, and/or 22₂ with a sampling rate that is, for example, at least 10 Hz, at least 100 Hz or at least one kHz such as in the MHz range or even in the GHz range. The control unit 62 may be configured to control the actuator 58 so as to provide the dynamic relative movement between the DuT 14 and the sensor array 18 with an amplitude of at least 1/100, at least 1/50, at least 1/20 or at least 1/10 and at most 1/2 of the sensor distance 64, the distance between two sensors and in an sensor array relative to the smallest and/or largest distance between two sensors along the movement axis/direction, respectively. I.e., a movement of the beam 22 when being projected into a plane of the sensor elements 16. Thus, a rotation and/or a lateral movement of the DuT 14 with respect to the sensor element 18 may lead to a movement of the beam 22 at a position of the sensor elements 16. The control unit is configured to control the actuator so as to provide the dynamic relative movement. This may be performed with a frequency of at least the sampling rate of the relevant frequency band. When referring to the Nyquist Criterion, at least a double of the maximum frequency to be measured may be the sampling rate. For a sub-Nyquist sampling, a sampling rate being the double of the relevant frequency bandwidth may be sufficient. Thus, frequencies below the sampling rate may be used (sub-nyquist sampling).

In other words: while the DuT is transmitting a static beam pattern from its surface the DuT and the Sensors are moved relatively to each other along a repeated trajectory e.g. swinging between two extreme positions in order to achieve virtual new sensor positions which act as increased density sensor distribution. I.e., the dynamic movement of the beam may be repeated. Such configuration allows for imaging resolutions beyond the theoretical sampling distance given by the sensor distribution.

Thus, the measurement system 70 may be implemented without the orienting movement, for example, when it is not necessary or when it is performed by another actuator or manually.

In such a case, the measurement system may comprise a placement structure (12) configured to hold a device under test (DuT) (14); a sensor array (18) configured to sense an electromagnetic radiation from the DuT (14) at a radio frequency; an actuator (58) configured to generate a dynamic relative movement between the DuT (14) and the sensor array (18); and/or a control unit (62) configured to control the actuator (58) so as to at least temporarily provide for the dynamic movement of a beam of the DuT with respect to the sensor array (14) such as the described swing movement. I.e., the dynamic movement may at least partially be generated by the actuator and/or at least partially be implemented by controlling the DuT.

A Method for measuring electromagnetic radiation of a device under test (DuT), may the comprise: holding the DuT with a placement structure; controlling the DuT so as to radiate a beam at a radio frequency, the beam traveling between the DuT and the sensor array; controlling an actuator so as to generate a dynamic relative movement between the DuT and the sensor array; and/or controlling the DuT such that a beam generated by the DuT is moved so as to at least partially implement the dynamic relative movement.

Both, the first aspect and the second aspect may be combined with each other. Thus, the measurement system 70 may be extended so as to comprise a lens structure such as the lens structure 24 effective at the radio frequency of the beam 22. The lens structure may be configured to be arranged between the DuT 14, the placement structure 12, respectively, and the sensor array 18. The lens structure may be configured to change a width of a beam of the electromagnetic radiation, the beam traveling from the DuT 14 to the sensor array 18 as described in connection with the first aspect.

Alternatively or in addition, a measurement system according to the first aspect such as the measurement systems 10, 30, 50 or 60 may be extended by a feature of the second aspect. For example, the measurement system 60 may comprise the control unit 62 configured to control the actuator 56 so as to at least temporarily provide for the described quasi-static relative movement so as to quasi-statically adapt an orientation of the DuT 14 with respect to the sensor array 18. The control unit may further be configured to control the actuator 56 so as to provide for a dynamic relative movement superimposing the quasi-static movement. As described in connection with Fig. 7, the dynamic movement may comprise an amplitude of at least 1/100 of the sensor distance and possibly at a frequency being at least the sampling rate of the relevant frequency band.

In other words, the first aspect comprises a combination of an array antenna with a lens of concave, convex and/or cylindrical form to widen and/or narrow an emitted beam with. The lens may be positioned at least temporarily in front of an antenna array of the DuT. An adapter or adapting structure may be used in order to allow a rotation of the lens against the array antenna and/or a shift of the lens structure relatively to a center of the array antenna. The recommendation of the lens structure is to widen and/or narrow the beam along certain axes. This allows to improve a resolution between multiple simultaneous limited beams. By this way, a distribution of sensors in OTA chambers may be exploited by superimposing it with different angular spreads of the same beams. Lens structures comprising dielectric lenses are known to passively form beams in front of antenna arrays for millimeter wave communication as explained in [1], [2], [3] and [4]. This may include to do beamforming with a kind of active antenna array in combination with beam diffraction in the lens. Embodiments use dielectric lenses in OTA measurements, amongst other things, as far-field converters in order to reduce the distance between the DuT and sensors in a measurement chamber.

Embodiments and examples of the first aspect and examples of the second aspect allow for a flexible sampling in angular/spatial domain with a fixed sensor distribution. Furthermore, embodiments allow to reduce and/or increase effective angular resolution coming from a fixed distribution of sensors in space. Instead of reconfiguring the sensor distribution and/or a number of sensor elements depending on carrier frequency, antenna type, e.g., a number of elements in an antenna array, the most appropriate lens shape may be selected to allow a good enough sampling resolution at minimum measurement time. Diffraction properties of a combination of antenna and lens may be learned upfront and may be used as transformation into a virtual measurement space (virtual sphere with an optimized number and positions of sensors). The described mechanisms allow measurements in near field, far field and in-between. Measurements of multiple beams emitted at the same time may allow to flexibly separate effective beams during measurements across various cuts.

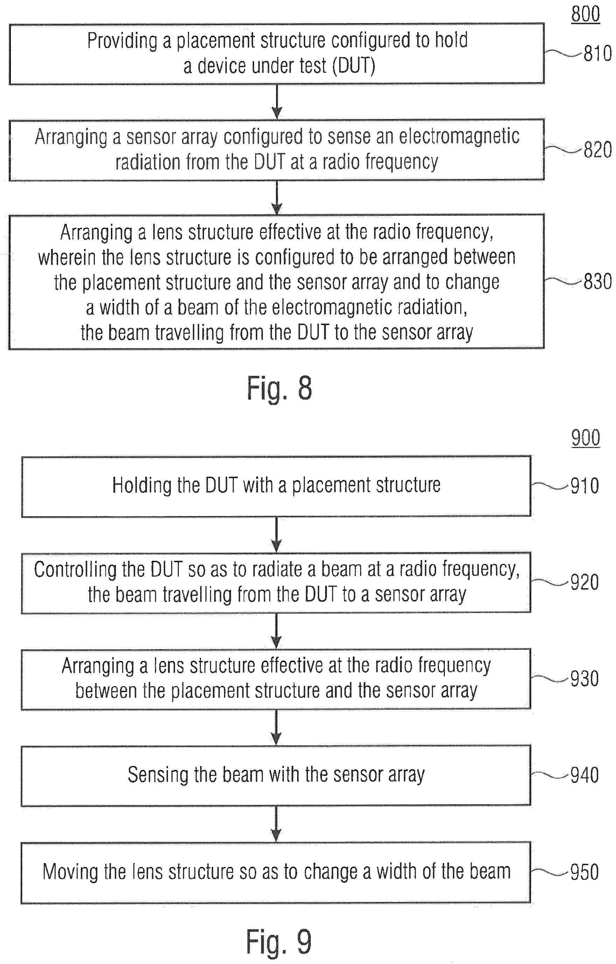

Fig. 8 shows a schematic flowchart of a method 800 for providing a measurement system such as the measurement system 10, 30, 50 and/or 60 according to the first aspect. The method comprises a step 810 in which a placement structure is provided, which is configured to hold a device under test (DuT). In a step 820 a sensor array is configured to sense an electromagnetic radiation from the DuT at a radio frequency is arranged. In a step 830, a lens structure effective at the radio frequency is arranged. The lens structure is configured to be arranged between the placement structure and the sensor array and to change a width of a beam of the electromagnetic radiation, the beam traveling from the DuT to the sensor array.

Fig. 9 shows a schematic flowchart of a method 900 for measuring electromagnetic radiation of a device under test. The method 900 may be implemented, for example, using a measurement system according to the first aspect. A step 910 comprises holding the DuT with a placement structure. A step 920 comprises controlling the DuT so as to radiate a beam at a radio frequency, the beam traveling from the DuT to a sensor array. A step 930 comprises arranging a lens structure effective at the radio frequency between the placement structure and the sensor array. A step 940 comprises sensing the beam with the sensor array. A step 950 comprises moving the lens structure so as to change a width of the beam. Step 950 may be performed repeatedly.

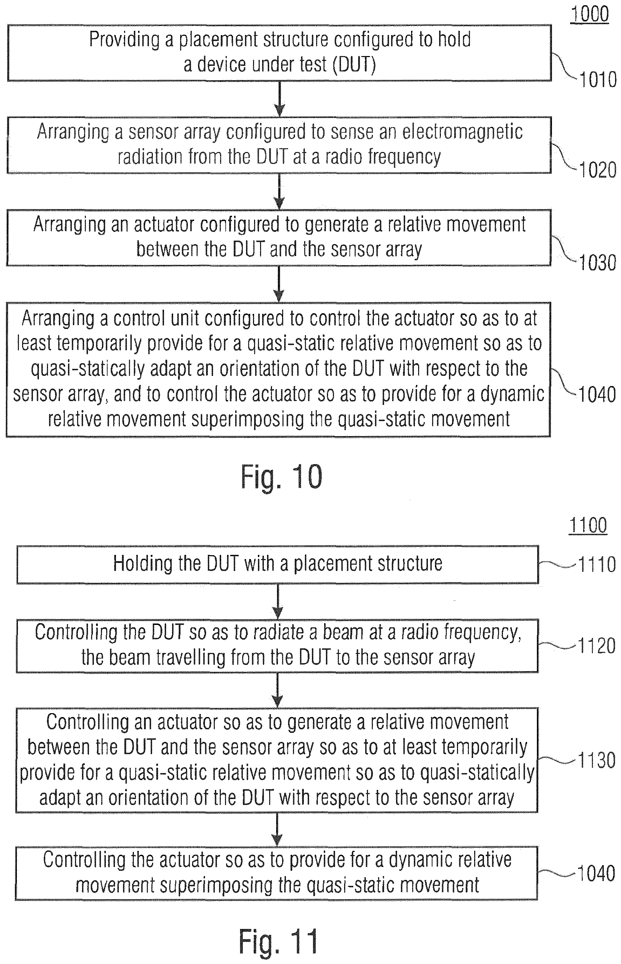

Fig. 10 shows a schematic flowchart of a method 1000 for providing a measurement system according to the second aspect, such as the measurement system 70. A step 1010 comprises providing a placement structure configured to hold a DuT. A step 1020 comprises arranging a sensor array configured to sense an electromagnetic radiation from the DuT at a radio frequency. A step 1030 comprises arranging an actuator configured to generate a relative movement between the DuT and the sensor array. A step 1040 comprises arranging a control unit configured to control the actuator so as to at least temporarily provide for a quasi-static relative movement so as to quasi-statically adapt an orientation of a DuT with respect to the sensor array, and to control the actuator so as to provide for a dynamic relative movement superimposing the quasi-static movement.

Fig. 11 shows a schematic flowchart of a method 1100 for measuring electromagnetic radiation of a DuT according to the second aspect. A step 1110 comprises holding the DuT with a placement structure. A step 1120 comprises controlling the DuT so as to radiate a beam at a radio frequency, the beam traveling from the DuT to the sensor array. A step 1130 comprises controlling an actuator so as to generate a relative movement between the DuT and the sensor array so as to at least temporarily provide for an orienting or quasi-static relative movement so as to quasi-statically adapt an orientation of the DuT with respect to the sensor array. A step 1140 comprises controlling the actuator so as to provide for a dynamic relative movement superimposing the orienting movement.

Measurements according to the second aspect may also be performed without the quasi-static movement such that an implementation of the measurement system 70 is also possible without the configuration of the actuator 58 for providing the quasi-static movement.

In the following, reference will be made to embodiments in accordance with the first aspect that comprise a reflecting structure as the beam pattern manipulator structure, wherein the reflecting structure may be arranged in combination with or as substitute for the lens structure described.

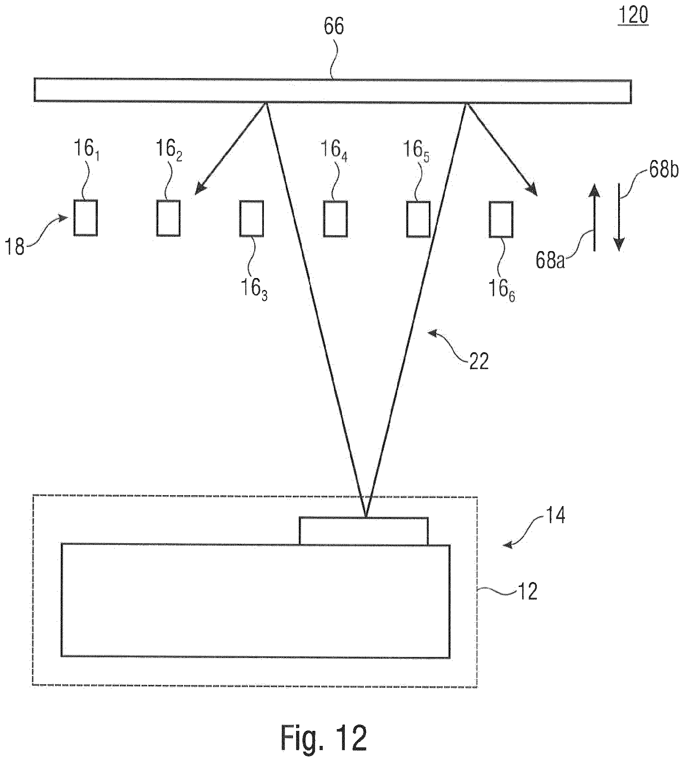

Fig. 12 shows a schematic block diagram of a measurement system 120 according to an embodiment in accordance with the first aspect. The beam pattern manipulator structure comprises a reflector structure 66 being configured to at least partially reflect the beam 22 and to thereby changing a direction of the beam 22. For example, a first direction 68a may point form the DuT 14 to the reflector structure 66. A second reflected direction 68b may be at least influenced from the first direction 68a, e.g., based on an angle of incidence of the direction 68a which may correspond to an angle of reflection.

The reflector structure may allow for virtually increasing the distance travelled by the electromagnetic radiation from the DuT to the sensor array 18, for example, when the beam 22 is first travelling past the sensor array 18, being afterwards reflected at the reflector structure 66 and arriving then at the sensor array 18. This effect may further be increased by implementing the beam pattern manipulator structure such that a multitude of reflections is obtained which may allow to reach far filed measurements in a tight space like a mirror cabinet or wave guide. According to embodiments, the reflector structure is configured to extend the travelled distance, i.e., the effective distance of the beam to travel between the DuT and the sensors/probes by at least 50 %, by at least 100 % or at least 150 % when compared to a direct LoS path in case the DuT and sensor array would face each at shortest distance. For example, the sensors 16₁ to16e may at least partially comprise an anisotropy of sensitivity that may allow to at least discriminating between the directions 68a and 68b of arrival. Thereby, when compared to a direct way or Line of Sight Path (LoS) between the DuT 14 and the sensor array 18, the travelling distance of the beam 22 may be increased by implementing one or more reflections. This may allow for building small measurement systems as by enlarging the travelling distance, the far field configuration of the beam 22 may be obtained even at low LoS distances. Alternatively or in addition, the reflecting structure 66 may allow for manipulating the beam 22, for example by allowing a further defocusing based on the travel distance which may lead to similar effects when compared to a defocusing lens.

The reflecting structure may be effective at the radio frequency, for example, by comprising a metallic structure having effects at a broadband frequency range. When compared to a lens structure, that may affect diffraction, the reflecting structure may provide advantages by avoiding diffraction. Furthermore the reflector structure may comprise wideband properties in its reflecting properties while the lens properties may be chosen for a given transmitted frequency such as e.g. 28 GHz or 60 GHz.

Although being shown as arranged between the DuT and the reflector structure 66, the sensor array 18 may at least partially be arranged at different positions, e.g., behind the DuT such that the DuT is arranged between the respective part of the sensor array 18 and the reflector structure 66 and/or behind the reflector structure 66 such that the reflector structure 66 is arranged along the effective path travelled by the radiated beam pattern under investigation between the respective part of the sensor array 18, e.g., when the reflector structure 66 comprises an irregular structure that is at least partially transparent for the beam.

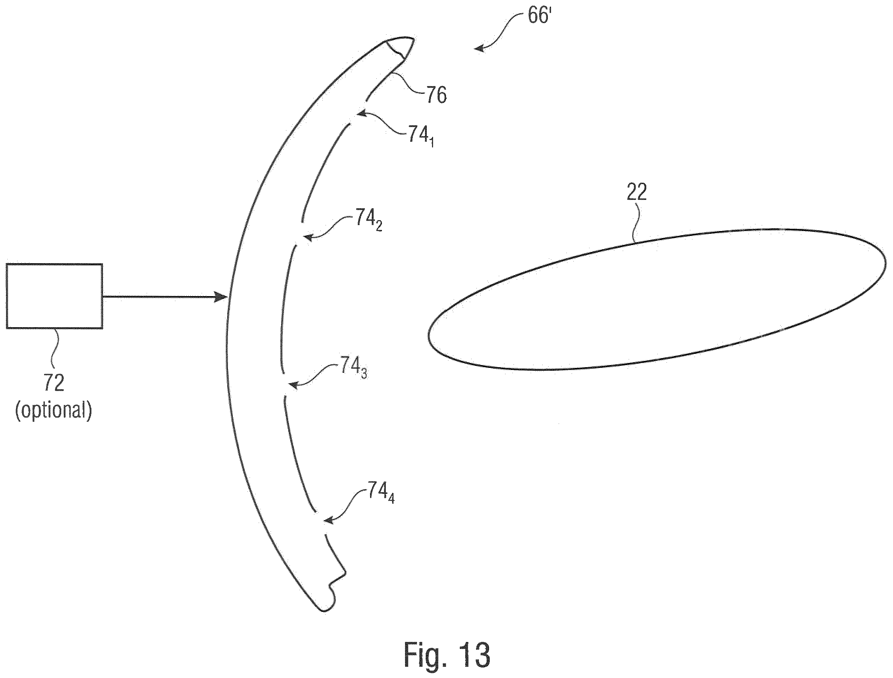

Fig. 13 shows a schematic side view of a reflecting structure 66' according to an embodiment. The reflector structure 66' may comprise a planar or non-planar surface, for example concave. Alternatively or in addition, the reflector structure 66' may at least partially comprise a convex portion. A concave shape may allow for focusing the beam 22, wherein a convex shape may allow for a defocusing, i.e., a spreading of the beam 22 when reflecting the beam 22.

Optionally, the reflector structure 66' may comprise a reconfigurable surface and an actuator 72 configured to reconfigure a shape of the surface so as to adapt a reflection property of the surface. This may include, but is not limited to varying a bending or curvature of the reflector surface 66', e.g., an amount of convex-curvature, an amount of concave-curvature or a change between convex and concave. Alternatively or in addition, the reflector structure 66' may comprise a number of irregular structures 74₁ to 74₄, wherein the number may be arbitrary, e.g., one or more, two or more, 10 or more or even 100 or more. Irregular structure may relate to being different from, i.e., irregular with respect to the reflecting surface 76. This may include openings, further elements as lenses, recesses, inquiries/elevations, local variations in reflection properties and/or diffraction points/regions.

One or more of the irregular structures 74₁ to 74₄ may be formed, for example as iris structures in a reflecting surface 76 of the reflector structure 66'. An iris structure may be or may comprise an aperture in the reflecting surface 76, i.e., the beam 22 may be at least partially be absorbed or transmitted by the reflector structure 66' at the regions of the iris structures. Both, absorption and transmission may allow for an extraction of a part of the beam in the region of the iris structure. Alternatively or in addition, the iris structure may at least partially comprise a reflecting surface. The reflective surface may be configured for providing a beam-manipulating functionality, e.g., a polarization or the like. A degree of extraction may be, for example, at least 50 %, at least 70 % or at least 90 % which may allow excluding a region of the iris structure in the reflected beam (portions of lower intensity). Alternatively, a degree of absorption may be at least 50 %, at least 70 % or at least 90 % at a region of the iris structure. Such portions of lower intensity may allow for using a high dynamic range in the sensor array 18, when excluding or damping extremely high or extremely low intensities. Alternatively or in addition, one or more irregular structures 74₁ to 74₄ may comprise a lens structure, for example, a lens structure 24. The lens structure 24 may be or at least comprise a mechanical structure such as a Fresnel lens.

The actuator 72 may be configured to adapt one or more of the irregular structures 74₁ to 74₄, e.g., by adapting a diameter or extension of the aperture of the iris, modifying a lens structure or the like. The actuator 72 may comprise, for example, pneumatic, hydraulic, electric/piezoelectric and/or mechanical actuator elements.

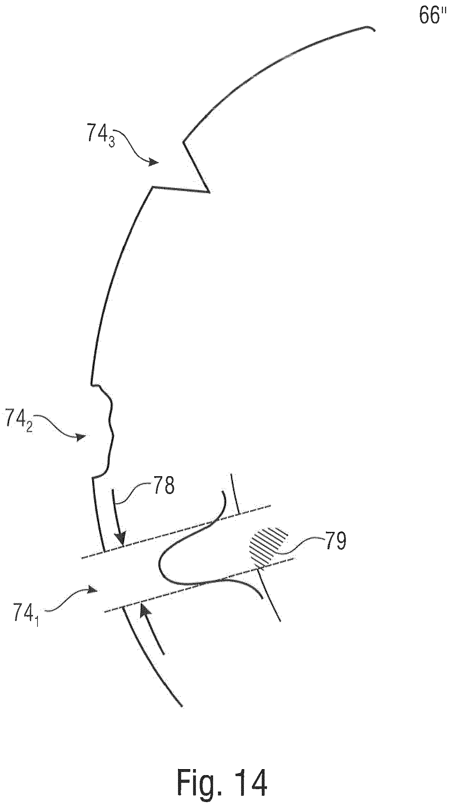

Fig. 14 shows a schematic side view of a reflector structure 66" according to an embodiment comprising the irregular structure 74, being formed as an iris structure having a variable aperture 78 for variably excluding or damping a region 79 in the beam. The irregular structure 74₂ may be formed as a recess such as a so-called Donut that may allow for a lens-like effect for an incoming beam. The irregular structure 74₃ may be formed V-shaped and may allow affecting a perturbation for the incoming beam. Further, other or different irregular structures may be arranged in any combination thereof. The irregular structures 74, to 74₃ may be arranged at or in a surface of the reflector structure66", for example on a surface and/or along a circumference of the reflecting structure. Although being described as round structures, reflector structures described herein may comprise an arbitrary shape adapted to specific test environments.

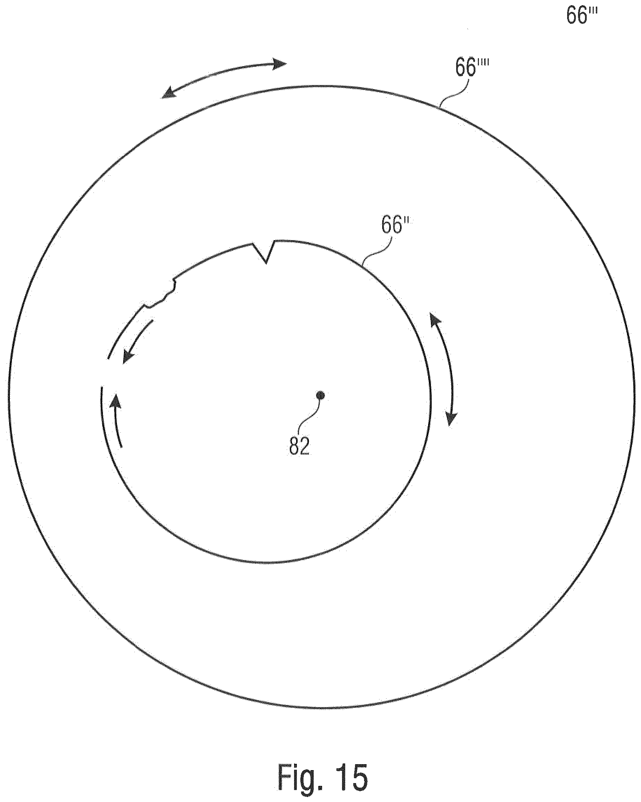

Fig. 15 shows a schematic view of a reflector structure 66‴ according to an embodiment comprising the reflector structure 66" forming a first layer structure of the reflector structure 66‴. A further reflector structure 66ʺʺ may form a second layer, i.e., the reflector structures 66" and 66ʺʺ may form a stack. The layers 66" and 66ʺʺ may be arranged with respect to each other in a way that the y may be moved with respect to each other along a linear or curved path, e.g., rotated with respect to each other, for example, using an actuator such as actuator 72. Each of the layers may comprise a coating that may allow for polarizing the incoming beam during reflection and/or that implements a half-reflecting surface. This may allow for a variation of the effect provided by the reflector structure 66‴ with respect to the beam, especially when the beam only hits a part of the reflector structure, for example, by exposing different irregular structures or different positions thereof to the beam 22, which may vary over time. Furthermore, the reflector structure 66‴ may be hinged off-center with respect to the reflector structure 66ʺʺ as indicated by an axis 82 which may allow for modifying a surface amount of the reflector structure 66"" exposed to the beam. For example, both layers 66" and 66ʺʺ may comprise different degrees of reflection/polarization. The reflector structure 66ʺʺ may comprise irregular structures such that along a beam direction more than one irregular structures may be passed. A different number than two layers may be implemented, e.g., 1, 3, 4 or even more, possibly 10.

Although the irregular structures are described as being combined with the reflector structure, the description provided also relates to a combination of irregular structures with lens structures. By providing, by non-limiting example, only, an opaque region on a lens surface, a region of absorption may be provided. When cutting out a region of the lens, a region of transmission may be provided, wherein both may be regarded as iris structure.

Although the irregular structures are described as being arranged on the reflecting structure or on the lens structure, also a cascade of irregular structures may be provided and/or a cascade of lens structures and/or reflector structures such as a reflector having an irregular structure, a lens structure on top of the irregular structure and possibly a further irregular structure on top of the lens, wherein a plurality of other configurations may be implemented.

Lens structures and reflector structures may be combined with each other, for example, a lens structure being arranged adjacent to a surface of a reflector structure.

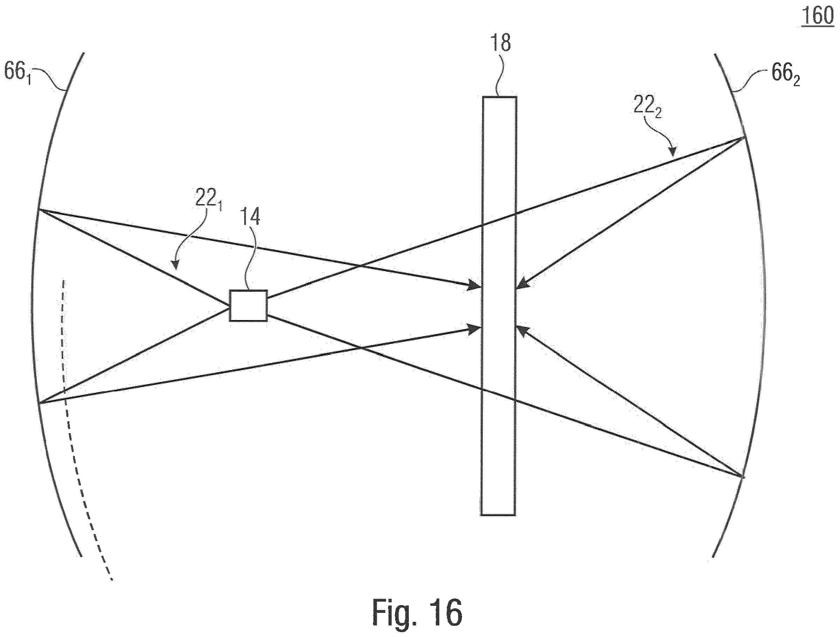

Fig. 16 shows a schematic diagram of a measurement system 160 according to an embodiment of the first aspect, the measurement system comprising a first reflecting structure 66, and a second reflecting structure 66₂, wherein a different number of reflecting structures may be implemented, e.g., at least one, at least two, at least four or more. Each of the reflecting structures 66 may be adapted as described with respect to the reflecting structures 66, 66', 66", 66‴ or 66"". One or more of the reflecting structures 66, and/or 66₂ may be moveable as indicated by the dotted lines. The sensor array 18 may be arranged between the device under test 14 and the reflector structure 66₂ and/or the device under test 14 may be arranged between the sensor array 18 and the reflector structure 66₁. The reflector structures 66₁ and 66₂ may be elements of a common reflector structure which may allow for reflecting/deflecting the beam at least twice or a higher number of times. The reflector structure may be configured to extend the effective distance between the DuT and the sensor array by at least 50 % when compared to a Line of Sight path between the sensor array and the DuT.

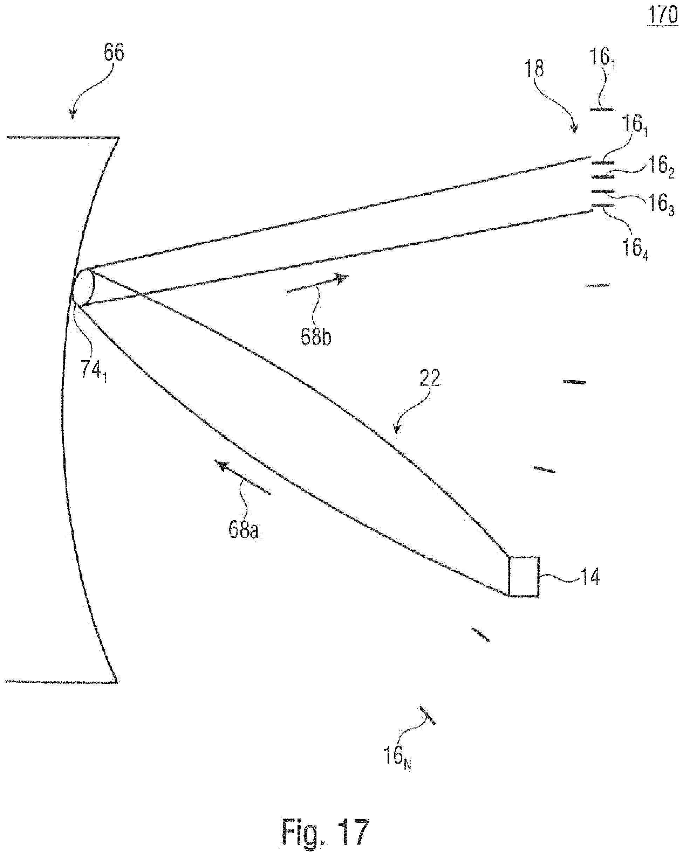

Fig. 17 shows a schematic block diagram of a measurement system 170 comprising the reflector structure 66. The reflector structure 66 may comprise the irregular structure 74₁ being or comprising a lens element which may allow focusing the beam 22 to a region of the sensor array 18 at which a spatial density of sensors 16₁ to 16ₙ is comparatively high, such that exact measurement results may be obtained. Based on a movement of the DuT 14, the reflector structure 66 and/or the irregular structure 74, diverse measurements may be executed.

As described above, embodiments described herein may be combined such that the beam pattern manipulator structure may comprise a lens structure and/or a reflector structure. Furthermore, embodiments may be configured to implement a dynamical movement and/or may comprise a beam pattern manipulator structure.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a data carrier having electronically readable control signals, which are capable of cooperating with a programmable computer system, such that one of the methods described herein is performed.

Generally, embodiments of the present invention can partially be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

### References

[1] Highly Directional Steerable Antennas: High-Gain Antennas Supporting User Mobility or Beam Switching for Reconfigurable Backhauling; A. Maltsev. A. Sadrl. A. Pudeyev and I. Bolotin, in IEEE Vehicular Technology Magazine, vol. 11. no. 1. pp. 32-39. March 2016.
[2] 2-D Beam-Steerable Integrated Lens Antenna System for 5G E-Band Access and Backhaul: Juha Ala-Laurinaho, Jouko Aurinsaio, Akl Karttunen, Member, IEEE, Mikko Kaunisto, Antti Lamminen, Juha Nurmlharju, Antti V. Räisänen, IEEE TRANSACTIONS ON MICROWAVE THEORY AND TECHNIQUES. VOL. 64, NO. 7. JULY 2016
[3] Plane Wave Converter for OTA Measurements, part of presentation given at 5G Summit. Berlin, Nov. 3rd, 2018
[4] RF Lens-Embedded Massive MIMO Systems: Fabrication Issues and Codebook Design: Taehoon Kwon, Student Member, IEEE, Yeon-Geun Lim, Student Member, IEEE, Byung-Wook Min, Member, IEEE, and Chan-Byoung Chae, Senior Member, IEEE; IEEE Transactions on Microwave Theory and Techniques, Volume: 64, Issue: 7, July 2016, pages 2256 - 2271

## Claims

1. Measurement system comprising (10; 30; 50; 60):
a placement structure (12) configured to hold a device under test, DuT (14);
a sensor array (18) configured to sense an electromagnetic radiation (22) from the DuT (14) at a radio frequency; and
a beam pattern manipulator structure effective at the radio frequency configured to manipulate a beam (22) of the electromagnetic radiation, the beam (22) traveling between the DuT (14) and the sensor array (18); wherein the beam pattern manipulator structure comprises a lens structure (24; 24a-e) configured to change the width of the beam (22) when traveling along a radiation direction (34) through the lens structure (24; 24a-e), **characterized in that** the lens structure (24; 24a-e) comprises a varying shape along a lens direction (32) perpendicular to the radiation direction such that at varying positions of the lens structure along the lens direction (32) between the DuT (14) and the sensor array (18), a varying effect of the lens structure (24; 24a-e) with respect to the beam (22) is obtained;
wherein the measurement system comprises an actuator (42) configured to move the beam pattern manipulator structure (24; 24a-e) with respect to the DuT (14) so as to vary the change of the width of the beam (22).

2. The measurement system according to claim 1, wherein the lens structure (24; 24a-e) comprises the varying shape between a first end (28a) and a second end (28b) of the lens structure (24; 24a-e) being arranged along the lens direction (32).

3. The measurement system according to claim 1 or 2, wherein the lens structure (24; 24a-e) is configured to be arranged between the placement structure (12) and the sensor array (18) and to change a width of a beam (22) of the electromagnetic radiation, the beam (22) between the DuT (14) and the sensor array (18).

4. Measurement system according to claim 3, wherein the lens structure (24; 24a-e) comprises at least partially a concave, convex and/or cylindrical shape.

5. Measurement system according to one of previous claims, wherein the beam pattern manipulator structure comprises lens structure (24d) extends along a main direction (32) between a first end (28a) and a second end (28b) perpendicular to a radiation direction (34) of the lens structure (24; 24a-e), wherein the lens structure (24; 24a-e) comprises a convex shape at the first end (28a), and comprises a polygon shape at the second end (28b).

6. Measurement system according to one of previous claims, wherein the measurement system comprises an adapter structure (46) being transparent for the electromagnetic radiation and being mechanically connectable to the DuT (14) at a first side (52b) and to the beam pattern manipulator structure (24; 24a-e) at a second side (52a).

7. Measurement system according to claim 6, wherein the adapter structure (46) comprises a same material as the beam pattern manipulator structure (24; 24a-e).

8. Measurement system according to one of previous claims, wherein the beam pattern manipulator structure (24; 24a-e) comprises a coating (54) effective at the radio frequency.

9. Measurement system according to one of previous claims, wherein the beam pattern manipulator structure comprises a lens structure (24c; 24d; 24e) comprising a rotational asymmetric shape, wherein the actuator is configured to rotate the lens structure (24c; 24d; 24e) such that the lens structure (24c; 24d; 24e) is configured to direct the beam (22) into a first direction in a first position of the lens structure and to direct the beam (22) into a second direction in a second position of the lens structure.

10. Measurement system according to one of previous claims, wherein the measurement system comprises an actuator (56) configured to generate a relative movement between the DuT (14) and the sensor array (18).

11. Measurement system according to claim 9, wherein the measurement system comprises a control unit (62) configured to control the actuator (56) so as to at least temporarily provide for an orienting relative movement so as to adapt an orientation of the DuT (14) with respect to the sensor array (18), and to control the actuator (56) so as to provide for a dynamic relative movement comprising a low amplitude and a high frequency, superimposing the orienting movement; and/or to control the DuT such that a beam generated by the DuT (14) is moved with the dynamic relative movement superimposing the orienting movement.

12. Measurement system according to claim 10 or 11, wherein sensors (16) of the sensor array (18) are spaced by a sensor distance (64) with respect to each other, wherein the sensors (16) of the sensor array (18) are configured to sense the electromagnetic radiation with a sampling rate;
wherein the measurement system comprises a control unit configured to control an actuator (56) so as to provide for a dynamic relative movement between the DuT (14) and the sensor array (18) with an amplitude of at least 1/100 of the sensor distance (64).

13. Measurement system according to one of previous claims, wherein the measurement system comprises a first actuator (42) configured to move the beam pattern manipulator structure (24; 24a-e) with respect to the DuT (14) so as to vary the change a manipulation the beam (22); and comprises a second actuator (56) configured to generate a relative movement between the DuT (14) and the sensor array (18);
wherein the measurement system comprises a control unit (62) configured to control the second actuator (56) and to control the first actuator (42) such that the beam pattern manipulator structure (24; 24a-e) adjusts the beam (22) to a first width at a first relative positon of the DuT (14) with respect to the sensor array (18); and to control the first actuator (42) such that the lens adjusts the beam to a second width at a second relative positon of the DuT (14) with respect to the sensor array (18).

14. Measurement system according to one of previous claims, wherein the sensor array(18) is configured to sense a far field of the electromagnetic radiation from the DuT (14).

15. Method (800) for providing a measurement system, the method comprising:
providing (810) a placement structure configured to hold a device under test, DuT;
arranging (820) a sensor array configured to sense an electromagnetic radiation from the DuT at a radio frequency; and
arranging (830) a lens structure effective at the radio frequency, wherein the lens structure is configured to be arranged between the placement structure and the sensor array and to change a width of a beam of the electromagnetic radiation, the
beam traveling between the DuT and the sensor array; wherein the lens structure (24; 24a-e) is configured to change the width of the beam (22) when traveling along a radiation direction (34) through the lens structure (24; 24a-e),
**characterized in that** the lens structure (24; 24a-e) comprises a varying shape along a lens direction (32) perpendicular to the radiation direction such that at varying positions of the lens structure along the lens direction (32) between the DuT (14) and the sensor array (18), a varying effect of the lens structure (24; 24a-e) with respect to the beam (22) is obtained;
and that the measurement system comprises an actuator (42) configured to move the beam pattern manipulator structure (24; 24a-e) with respect to the DuT (14) so as to vary the change of the width of the beam (22).

## Patentansprüche

1. Messsystem, das folgende Merkmale aufweist (10; 30; 50; 60):
eine Platzierungsstruktur (12), die dazu konfiguriert ist, einen Prüfling (14) zu halten;
ein Sensorarray (18), das dazu konfiguriert ist, eine elektromagnetische Strahlung (22) von dem Prüfling (14) auf einer Hochfrequenz zu erfassen; und
eine Strahlenmustermanipuliererstruktur, die auf der Hochfrequenz wirksam ist, die dazu konfiguriert ist, einen Strahl (22) der elektromagnetischen Strahlung zu manipulieren, wobei sich der Strahl (22) zwischen dem Prüfling (14) und dem Sensorarray (18) bewegt; wobei
die Strahlenmustermanipuliererstruktur eine Linsenstruktur (24; 24a-e) aufweist, die dazu konfiguriert ist, die Breite des Strahls (22) zu verändern, wenn sich derselbe entlang einer Strahlungsrichtung (34) durch die Linsenstruktur (24; 24a-e) bewegt, **dadurch gekennzeichnet, dass** die Linsenstruktur (24; 24a-e) eine variable Form entlang einer Linsenrichtung (32) aufweist, die senkrecht zu der Strahlungsrichtung verläuft, sodass an variablen Positionen der Linsenstruktur entlang der Linsenrichtung (32) zwischen dem Prüfling (14) und dem Sensorarray (18) eine variable Wirkung der Linsenstruktur (24; 24a-e) bezüglich des Strahls (22) erhalten wird;
wobei das Messsystem einen Aktuator (42) aufweist, der dazu konfiguriert ist, die Strahlenmustermanipuliererstruktur (24; 24a-e) bezüglich des Prüflings (14) zu bewegen, um die Veränderung der Breite des Strahls (22) zu variieren.

2. Das Messsystem gemäß Anspruch 1, bei dem die Linsenstruktur (24; 24a-e) die variable Form zwischen einem ersten Ende (28a) und einem zweiten Ende (28b) der Linsenstruktur (24; 24a-e) aufweist, die entlang der Linsenrichtung (32) angeordnet ist.

3. Das Messsystem gemäß Anspruch 1 oder 2, bei dem die Linsenstruktur (24; 24a-e) dazu konfiguriert ist, zwischen der Platzierungsstruktur (12) und dem Sensorarray (18) angeordnet zu sein und eine Breite eines Strahls (22) der elektromagnetischen Strahlung zu verändern, wobei der Strahl (22) zwischen dem Prüfling (14) und dem Sensorarray (18) verläuft.

4. Messsystem gemäß Anspruch 3, bei dem die Linsenstruktur (24; 24a-e) zumindest teilweise eine konkave, konvexe und/oder zylindrische Form aufweist.

5. Messsystem gemäß einem der vorhergehenden Ansprüche, bei dem die Strahlenmustermanipuliererstruktur eine Linsenstruktur (24d) aufweist, die sich entlang einer Hauptrichtung (32) zwischen einem ersten Ende (28a) und einem zweiten Ende (28b), senkrecht zu einer Strahlungsrichtung (34) der Linsenstruktur (24; 24a-e) erstreckt, wobei die Linsenstruktur (24; 24a-e) eine konvexe Form an dem ersten Ende (28a) aufweist und eine Polygonform an dem zweiten Ende (28b) aufweist.

6. Messsystem gemäß einem der vorhergehenden Ansprüche, wobei das Messsystem eine Adapterstruktur (46) aufweist, die für die elektromagnetische Strahlung durchlässig ist und auf einer ersten Seite (52b) mit dem Prüfling (14) und auf einer zweiten Seite (52a) mit der Strahlenmustermanipuliererstruktur (24; 24a-e) mechanisch verbindbar ist.

7. Messsystem gemäß Anspruch 6, bei dem die Adapterstruktur (46) ein gleiches Material wie die Strahlenmustermanipuliererstruktur (24; 24a-e) aufweist.

8. Messsystem gemäß einem der vorhergehenden Ansprüche, bei dem die Strahlenmustermanipuliererstruktur (24; 24a-e) eine Beschichtung (54) aufweist, die auf der Hochfrequenz wirksam ist.

9. Messsystem gemäß einem der vorhergehenden Ansprüche, bei dem die Strahlenmustermanipuliererstruktur eine Linsenstruktur (24c; 24d; 24e) aufweist, die eine rotationsasymmetrische Form aufweist, wobei der Aktuator dazu konfiguriert ist, die Linsenstruktur (24c; 24d; 24e) derart zu drehen, dass die Linsenstruktur (24c; 24d; 24e) dazu konfiguriert ist, den Strahl (22) in einer ersten Position der Linsenstruktur in eine erste Richtung zu richten und den Strahl (22) in einer zweiten Position der Linsenstruktur in eine zweite Richtung zu richten.

10. Messsystem gemäß einem der vorhergehenden Ansprüche, wobei das Messsystem einen Aktuator (56) aufweist, der dazu konfiguriert ist, zwischen dem Prüfling (14) und dem Sensorarray (18) eine relative Bewegung zu erzeugen.

11. Messsystem gemäß Anspruch 9, wobei das Messsystem eine Steuereinheit (62) aufweist, die dazu konfiguriert ist, den Aktuator (56) zu steuern, um zumindest vorübergehend für eine orientierende Relativbewegung zu sorgen, um eine Orientierung des Prüflings (14) bezüglich des Sensorarrays (18) anzupassen, und den Aktuator (56) zu steuern, um für eine dynamische Relativbewegung zu sorgen, die eine niedrige Amplitude und eine hohe Frequenz aufweist und die der Orientierungsbewegung überlagert ist; und/oder den Prüfling derart zu steuern, dass ein von dem Prüfling (14) erzeugter Strahl mit der dynamischen Relativbewegung, die der Orientierungsbewegung überlagert ist, bewegt wird.

12. Messsystem gemäß Anspruch 10 oder 11, bei dem die Sensoren (16) des Sensorarrays (18) um einen Sensorabstand (64) voneinander beabstandet sind, wobei die Sensoren (16) des Sensorarrays (18) dazu konfiguriert sind, die elektromagnetische Strahlung mit einer Abtastrate zu erfassen;
wobei das Messsystem eine Steuereinheit aufweist, die dazu konfiguriert ist, einen Aktuator (56) zu steuern, um für eine dynamische Relativbewegung zwischen dem Prüfling (14) und dem Sensorarray (18) mit einer Amplitude von mindestens 1/100 des Sensorabstands (64) zu sorgen.

13. Messsystem gemäß einem der vorhergehenden Ansprüche, wobei das Messsystem einen ersten Aktuator (42) aufweist, der dazu konfiguriert ist, die Strahlenmustermanipuliererstruktur (24; 24a-e) bezüglich des Prüflings (14) zu bewegen, um die Veränderung einer Manipulation des Strahls (22) zu variieren; und einen zweiten Aktuator (56) aufweist, der dazu konfiguriert ist, eine Relativbewegung zwischen dem Prüfling (14) und dem Sensorarray (18) zu erzeugen;
wobei das Messsystem eine Steuereinheit (62) aufweist, die dazu konfiguriert ist, den zweiten Aktuator (56) zu steuern und den ersten Aktuator (42) derart zu steuern, dass die Strahlenmustermanipuliererstruktur (24; 24a-e) den Strahl (22) an einer ersten relativen Position des Prüflings (14) bezüglich des Sensorarrays (18) auf eine erste Breite einstellt; und den ersten Aktuator (42) derart zu steuern, dass die Linse den Strahl an einer zweiten relativen Position des Prüflings (14) bezüglich des Sensorarrays (18) auf eine zweite Breite einstellt.

14. Messsystem gemäß einem der vorhergehenden Ansprüche, bei dem das Sensorarray (18) dazu konfiguriert ist, ein Fernfeld der elektromagnetischen Strahlung von dem Prüfling (14) zu erfassen.

15. Verfahren (800) zum Bereitstellen eines Messsystems, wobei das Verfahren folgende Schritte aufweist:
Bereitstellen (810) einer Platzierungsstruktur, die dazu konfiguriert ist, einen Prüfling zu halten;
Anordnen (820) eines Sensorarrays, das dazu konfiguriert ist, eine elektromagnetische Strahlung von dem Prüfling auf einer Hochfrequenz zu erfassen; und
Anordnen (830) einer Linsenstruktur, die auf der Hochfrequenz wirksam ist, wobei die Linsenstruktur dazu konfiguriert ist, zwischen der Platzierungsstruktur und dem Sensorarray angeordnet zu sein und eine Breite eines Strahls der elektromagnetischen Strahlung zu verändern, wobei sich der Strahl zwischen dem Prüfling und dem Sensorarray bewegt; wobei
die Linsenstruktur (24; 24a-e) dazu konfiguriert ist, die Breite des Strahls (22) zu verändern, wenn sich derselbe entlang einer Strahlungsrichtung (34) durch die Linsenstruktur (24; 24a-e) bewegt,
**dadurch gekennzeichnet,**
**dass** die Linsenstruktur (24; 24a-e) eine variable Form entlang einer Linsenrichtung (32) aufweist, die senkrecht zu der Strahlungsrichtung verläuft, sodass an variablen Positionen der Linsenstruktur entlang der Linsenrichtung (32) zwischen dem Prüfling (14) und dem Sensorarray (18) eine variable Wirkung der Linsenstruktur (24; 24a-e) bezüglich des Strahls (22) erhalten wird;
und **dass** das Messsystem einen Aktuator (42) aufweist, der dazu konfiguriert ist, die Strahlenmustermanipuliererstruktur (24; 24a-e) bezüglich des Prüflings (14) zu bewegen, um die Veränderung der Breite des Strahls (22) zu variieren.

## Revendications

1. Système de mesure (10; 30; 50; 60), comprenant:
une structure de placement (12) configurée pour maintenir un dispositif sous test, DuT (14);
un réseau de capteurs (18) configuré pour détecter un rayonnement électromagnétique (22) provenant du DuT (14) à une radiofréquence; et
une structure de manipulateur de modèle de faisceau efficace à la radiofréquence configurée pour manipuler un faisceau (22) de rayonnement électromagnétique, le faisceau (22) se déplaçant entre le DuT (14) et le réseau de capteurs (18);
dans lequel la structure de manipulateur de modèle de faisceau comprend une structure de lentille (24; 24a à e) configurée pour modifier la largeur du faisceau (22) lorsqu'il se déplace dans une direction de rayonnement (34) à travers la structure de lentille (24; 24a à e),
**caractérisé par le fait que** la structure de lentille (24; 24a à e) comprend une forme variable dans une direction de lentille (32) perpendiculaire à la direction de rayonnement de sorte qu'à des positions variables de la structure de lentille dans la direction de lentille (32) entre le DuT (14) et le réseau de capteurs (18) soit obtenu un effet variable de la structure de lentille (24; 24a à e) par rapport au faisceau (22);
dans lequel le système de mesure comprend un actionneur (42) configuré pour déplacer la structure de manipulateur de modèle de faisceau (24; 24a à e) par rapport au DuT (14) de manière à faire varier la modification de la largeur du faisceau (22).

2. Système de mesure selon la revendication 1, dans lequel la structure de lentille (24; 24a à e) comprend la forme variable entre une première extrémité (28a) et une deuxième extrémité (28b) de la structure de lentille (24; 24a à e) qui est disposée dans la direction de la lentille (32).

3. Système de mesure selon la revendication 1 ou 2, dans lequel la structure de lentille (24; 24a à e) est configurée pour être disposée entre la structure de placement (12) et le réseau de capteurs (18) et pour modifier la largeur d'un faisceau (22) du rayonnement électromagnétique, le faisceau (22) entre le DuT (14) et le réseau de capteurs (18).

4. Système de mesure selon la revendication 3, dans lequel la structure de lentille (24; 24a à e) comprend au moins partiellement une forme concave, convexe et/ou cylindrique.

5. Système de mesure selon l'une des revendications précédentes, dans lequel la structure de manipulateur de modèle de faisceau comprend une structure de lentille (24d) qui s'étend dans une direction principale (32) entre une première extrémité (28a) et une deuxième extrémité (28b) de manière perpendiculaire à une direction de rayonnement (34) de la structure de lentille (24; 24a à e), dans lequel la structure de lentille (24; 24a à e) comprend une forme convexe au niveau de la première extrémité (28a), et comprend une forme polygonale au niveau de la deuxième extrémité (28b).

6. Système de mesure selon l'une des revendications précédentes, dans lequel le système de mesure comprend une structure d'adaptateur (46) qui est transparente au rayonnement électromagnétique et qui peut être connectée mécaniquement au DuT (14) d'un premier côté (52b) et à la structure de manipulateur de modèle de faisceau (24; 24a à e) d'un deuxième côté (52a).

7. Système de mesure selon la revendication 6, dans lequel la structure d'adaptateur (46) comprend un même matériau que la structure de manipulateur de modèle de faisceau (24; 24a à e).

8. Système de mesure selon l'une des revendications précédentes, dans lequel la structure de manipulateur de modèle de faisceau (24; 24a à e) comprend un revêtement (54) efficace à la radiofréquence.

9. Système de mesure selon l'une des revendications précédentes, dans lequel la structure de manipulateur de modèle de faisceau comprend une structure de lentille (24c; 24d; 24e) comprenant une forme asymétrique en rotation, dans lequel l'actionneur est configuré pour faire tourner la structure de lentille (24c; 24d; 24e) de sorte que la structure de lentille (24c; 24d; 24e) soit configurée pour diriger le faisceau (22) vers une première direction dans une première position de la structure de lentille et pour diriger le faisceau (22) vers une deuxième direction dans une deuxième position de la structure de la lentille.

10. Système de mesure selon l'une des revendications précédentes, dans lequel le système de mesure comprend un actionneur (56) configuré pour générer un mouvement relatif entre le DuT (14) et le réseau de capteurs (18).

11. Système de mesure selon la revendication 9, dans lequel le système de mesure comprend une unité de commande (62) configurée pour commander l'actionneur (56) de manière à créer au moins temporairement un mouvement relatif d'orientation de manière à adapter une orientation du DuT (14) par rapport au réseau de capteurs (18), et pour commander l'actionneur (56) de manière à créer un mouvement relatif dynamique comprenant une faible amplitude et une haute fréquence, venant en superposition avec le mouvement d'orientation; et/ou pour commander le DuT de sorte qu'un faisceau généré par le DuT (14) soit déplacé par le mouvement relatif dynamique venant en superposition avec le mouvement d'orientation.

12. Système de mesure selon la revendication 10 ou 11, dans lequel les capteurs (16) du réseau de capteurs (18) sont distants l'un de l'autre d'une distance de capteur (64), dans lequel les capteurs (16) du réseau de capteurs (18) sont configurés pour détecter le rayonnement électromagnétique à un taux d'échantillonnage;
dans lequel le système de mesure comprend une unité de commande configurée pour commander un actionneur (56) de manière à créer un mouvement relatif dynamique entre le DuT (14) et le réseau de capteurs (18) avec une amplitude d'au moins 1/100 de la distance de capteur (64).

13. Système de mesure selon l'une des revendications précédentes, dans lequel le système de mesure comprend un premier actionneur (42) configuré pour déplacer la structure de manipulateur de modèle de faisceau (24; 24a à e) par rapport au DuT (14) de manière à faire varier la modification de la largeur du faisceau (22); et comprend un deuxième actionneur (56) configuré pour générer un mouvement relatif entre le DuT (14) et le réseau de capteurs (18);
dans lequel le système de mesure comprend une unité de commande (62) configurée pour commander le deuxième actionneur (56) et pour commander le premier actionneur (42) de sorte que la structure de manipulateur de modèle de faisceau (24; 24a à e) ajuste le faisceau (22) à une première largeur à une première position relative du DuT (14) par rapport au réseau de capteurs (18); et pour commander le premier actionneur (42) de sorte que la lentille ajuste le faisceau à une deuxième largeur à une deuxième position relative du DuT (14) par rapport au réseau de capteurs (18).

14. Système de mesure selon l'une des revendications précédentes, dans lequel le réseau de capteurs (18) est configuré pour détecter un champ lointain du rayonnement électromagnétique du DuT (14).

15. Procédé (800) permettant de créer un système de mesure, le procédé comprenant le fait de:
prévoir (810) une structure de placement configurée pour contenir un dispositif sous test, DuT;
disposer (820) un réseau de capteurs configuré pour détecter un rayonnement électromagnétique provenant du DuT à une radiofréquence; et
disposer (830) une structure de lentille efficace à la radiofréquence, où la structure de lentille est configurée pour être disposée entre la structure de placement et le réseau de capteurs et pour modifier la largeur d'un faisceau du rayonnement électromagnétique, le faisceau se déplaçant entre le DuT et le réseau de capteurs;
dans lequel la structure de lentille (24; 24a à e) est configurée pour modifier la largeur du faisceau (22) lors du déplacement dans une direction de rayonnement (34) à travers la structure de lentille (24; 24a à e),
**caractérisé par le fait que** la structure de lentille (24; 24a à e) comprend une forme variable dans une direction de lentille (32) perpendiculaire à la direction de rayonnement de sorte qu'à des positions variables de la structure de lentille dans la direction de lentille (32) entre le DuT (14) et le réseau de capteurs (18) soit obtenu un effet variable de la structure de lentille (24; 24a à e) par rapport au faisceau (22);
et que le système de mesure comprend un actionneur (42) configuré pour déplacer la structure de manipulateur de modèle de faisceau (24; 24a à e) par rapport au DuT (14) de manière à faire varier la modification de la largeur du faisceau (22).
